# EUROPEAN PATENT APPLICATION

(11) **EP 4 565 044 A1**
(43) Date of publication of application: **04.06.2025**
(21) Application number: 24213739.6
(22) Date of filing: 18.11.2024
(51) Int. Cl.: H10K 59/122, H10K 59/80, H10K 50/844, H10K 50/824, H10K 50/858

(54) **DISPLAY PANEL AND METHOD OF MANUFACTURING THE SAME**

(30) Priority: 28.11.2023 KR 20230168508
(71) Applicant: Samsung Display Co., Ltd., Yongin-si Gyeonggi-do (KR)
(72) Inventor: SHIN, Hyuneok, Yongin-si (KR); PARK, Joonyong, Yongin-si (KR); SONG, Dokeun, Yongin-si (KR); YANG, Sukyoung, Yongin-si (KR); LEE, Dongmin, Yongin-si (KR)
(74) Representative: Marks & Clerk LLP

(57) **Abstract**

A display panel includes a base layer, a pixel defining film disposed on the base layer and including a light emitting opening portion, a bank disposed on the pixel defining film, having conductivity and including a bank opening portion overlapping the light emitting opening portion, a light emitting element disposed in the light emitting opening portion, and including an anode, an intermediate layer disposed on the anode, and a cathode disposed on the intermediate layer, an auxiliary electrode disposed on the cathode and connected to the cathode and the bank, and an encapsulation layer covering the light emitting element. A refractive index of the auxiliary electrode is less than or equal to a refractive index of the encapsulation layer.

## Description

### BACKGROUND

Embodiments relate to a display device, and more particularly, to a display panel with improved display quality, and a display device including the display panel.

Display devices such as televisions, monitors, smartphones, and tablet computers, which provide users with images, include display panels that display the images. Various display panels such as liquid crystal display panels, organic light emitting display panels, electrowetting display panels, and electrophoretic display panels, are developed as display panels.

An organic light emitting display panel may include an anode, a cathode, and a light emitting pattern. The light emitting pattern may be separated for each light emitting area, and the cathode may supply a common voltage to each light emitting area.

### SUMMARY

Embodiments provide a display panel capable of improving display quality and including a light emitting element formed without using a metal mask, and a method for manufacturing the display panel.

However, embodiments are not limited to those set forth herein. The above and other embodiments will become more apparent to one of ordinary skill in the art to which the disclosure pertains by referencing the detailed description of the disclosure given below.

An embodiment provides a display panel including a base layer, a pixel defining film disposed on the base layer and including a light emitting opening portion, a bank disposed on the pixel defining film, having conductivity, and including a bank opening portion overlapping the light emitting opening portion, a light emitting element, disposed in the light emitting opening portion, and including an anode, an intermediate layer disposed on the anode, and a cathode disposed on the intermediate layer, an auxiliary electrode disposed on the cathode and connected to the cathode and the bank, and an encapsulation layer covering the light emitting element. A refractive index of the auxiliary electrode may be less than or equal to a refractive index of the encapsulation layer.

In an embodiment, the auxiliary electrode may include a transparent conductive oxide (TCO).

In an embodiment, the auxiliary electrode may include an indium tin oxide (ITO).

In an embodiment, the auxiliary electrode may further include a group 2 element.

In an embodiment, a content of the group 2 element included in the auxiliary electrode may be in a range of about 1 at% to about 5 at%.

In an embodiment, the content of the group 2 element in the auxiliary electrode may be in a range of about 1 at% to about 3 at%.

In an embodiment, the auxiliary electrode may have a thickness in a range of about 100 angstrom (Å) to about 1000 angstrom (Å).

In an embodiment, the refractive index of the auxiliary electrode may be about 1.9 or less in a wavelength range of 380 nm to 760 nm.

In an embodiment, the auxiliary electrode may have an amorphous structure.

In an embodiment, the bank may have an undercut shape on a cross-section. The bank may include a lower layer including a conductive material, and an upper layer disposed on the lower layer, and the auxiliary electrode may extend along an inner side surface of the lower layer.

In an embodiment, the cathode may be in contact with the inner side surface of the lower layer, and the auxiliary electrode may extend via an end portion of the cathode to be in contact with the inner side surface.

In an embodiment, a size of an area, on which the auxiliary electrode is in contact with an inner side surface of the bank, may be greater than an area on which the cathode is in contact with the inner side surface of the bank.

In an embodiment, a display panel may include a base layer, a pixel defining film disposed on the base layer and including a light emitting opening portion, a bank disposed on the pixel defining film, having conductivity, and including a bank opening portion overlapping the light emitting opening portion, a light emitting element disposed in the light emitting opening portion and including an anode, an intermediate layer disposed on the anode, and a cathode disposed on the intermediate layer, an auxiliary electrode disposed on the cathode and connected to each of the cathode and the bank. The auxiliary electrode may include an indium tin oxide (ITO) doped with a group 2 element.

In an embodiment, the display panel may further include an encapsulation layer that covers the light emitting element, and a refractive index of the auxiliary electrode may be less than or equal to a refractive index of the encapsulation layer.

In an embodiment, the group 2 element may include at least one of magnesium (Mg) and calcium (Ca).

In an embodiment, a method for manufacturing a display panel may include providing a preliminary display panel including a base layer, an anode disposed on the base layer, and a preliminary pixel defining film that is disposed on the base layer and covers the anode, forming a bank disposed on the preliminary pixel defining film, and including a bank opening portion, forming a pixel defining film by patterning the preliminary pixel defining film to form a light emitting opening portion, which overlaps the bank opening portion and exposes at least a portion of the anode, forming a light emitting layer, a cathode disposed on the light emitting layer, and a preliminary auxiliary electrode in contact with the bank in the bank opening portion, forming an auxiliary electrode by doping the preliminary auxiliary electrode with a group 2 element, and forming an encapsulation layer covering the bank opening portion and having a refractive index greater than or equal to a refractive index of the auxiliary electrode.

In an embodiment, the light emitting layer and the cathode may be formed by a thermal evaporation method, and the auxiliary electrode may be formed by a different method from the cathode.

In an embodiment, the auxiliary electrode may be formed by a sputtering process.

In an embodiment, the preliminary auxiliary electrode may be doped with the group 2 elements so that a content of the group 2 elements included in the auxiliary electrode may be in a range of about 1 at% to about 5 at%.

In an embodiment, the forming of the bank may include forming a first layer on the pixel defining film, forming a second layer on the first layer, first etching of patterning the first layer and the second layer so that a first pattern may be formed, and second etching of patterning the first layer and the second layer so that an undercut may be formed in the first pattern.

At least some of the above and other features of the invention are set out in the claims.

### BRIEF DESCRIPTION OF THE DRAWINGS

The accompanying drawings are included to provide a further understanding of the invention, and are incorporated in and constitute a part of this specification. The drawings illustrate embodiments and, together with the description, serve to explain principles of the invention. In the drawings:
FIG. 1A is a schematic perspective view of a display device according to an embodiment;
FIG. 1B is an exploded schematic perspective view of a display device according to an embodiment;
FIG. 2 is a schematic cross-sectional view of a display module according to an embodiment;
FIG. 3 is a schematic plan view of a display panel according to an embodiment;
FIG. 4 is a schematic diagram of an equivalent circuit of a pixel according to an embodiment;
FIG. 5 is an enlarged schematic plan view of a portion of a display panel according to an embodiment;
FIG. 6 is a schematic cross-sectional view of a portion of a display panel according to an embodiment;
FIG. 7 is an enlarged schematic cross-sectional view of a portion of a display panel according to an embodiment;
FIG. 8 is a schematic cross-sectional view of a portion of a display panel according to an embodiment;
FIG. 9 is an enlarged schematic cross-sectional view of a portion of a display panel according to an embodiment; and
FIGS. 10A, 10B, 10C, 10D, 10E, 10F, 10G, 10H, 10I, and 10J are schematic cross-sectional views illustrating some of the operations of a method for manufacturing a display panel according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Hereinafter, a display panel and a method for manufacturing the same according to an embodiment will be described with reference to the accompanying drawings.

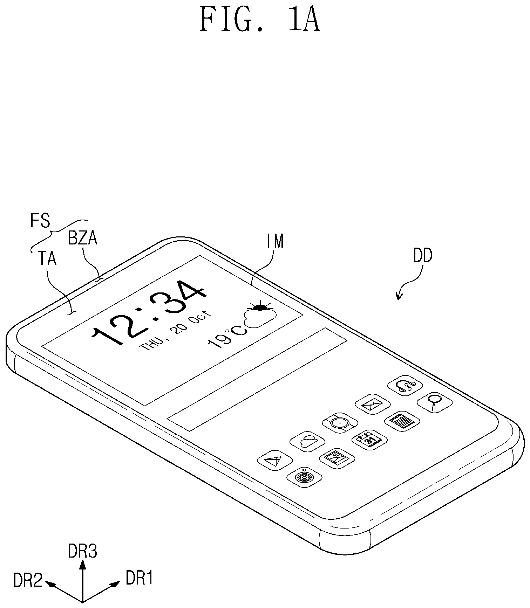

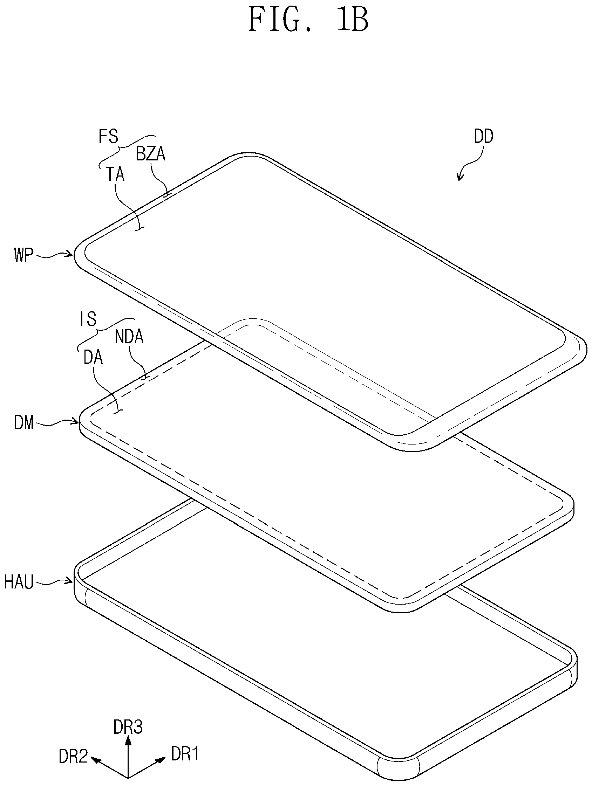

FIG. 1A is a schematic perspective view of a display device according to an embodiment. FIG. 1B is an exploded schematic perspective view of a display device according to an embodiment.

In an embodiment, a display device DD may be a large-sized electronic device such as a television, a monitor, or an outdoor billboard. For example, the display device DD may be a small-sized electronic device and a medium-sized electronic device such as a personal computer, a notebook computer, a personal digital assistant, a vehicle navigation unit, a game console, a smartphone, a tablet computer, and a camera. However, the foregoing devices are examples, and the display device DD may also be implemented as various display devices. FIGS. 1A and 1B illustrate a smartphone as an example of the display device DD.

Referring to FIGS. 1A and 1B, the display device DD may display an image IM in a third direction DR3 on a display surface FS parallel to each of a first direction DR1 and a second direction DR2. The image IM may include not only a dynamic image but also a still image. FIG. 1A illustrates a clock window and icons as an example of the image IM. The display surface FS on which the image IM is displayed may correspond to a front surface of the display device DD.

In an embodiment, a front surface (or top surface) and a rear surface (or bottom surface) of each member may be defined based on a direction in which the image IM is displayed. The front surface and the rear surface may be opposite to each other in the third direction DR3, and a normal direction to each of the front surface and the rear surface may be parallel to the third direction DR3. For example, directions indicated by the first to third directions DR1, DR2 and DR3 are relative concepts and may be changed to other directions. The term "on a plane" or "in plan view" used herein may mean a state when viewed in the third direction DR3.

The display device DD may include a window WP, a display module DM, and a housing HAU. The window WP and the housing HAU may be coupled to each other to form an outer appearance of the display device DD.

The window WP may include an optically transparent insulation material. For example, the window WP may include glass or plastic. A front surface of the window WP may define the display surface FS of the display device DD. The display surface FS may include a transmission area TA and a bezel area BZA. The transmission area TA may be an optically transparent area. For example, the transmission area TA may be an area having a visible light transmittance of about 90% or more.

The bezel area BZA may be an area having a relatively low light transmittance compared to the transmission area TA. The bezel area BZA may define a shape of the transmission area TA. The bezel area BZA may be adjacent to the transmission area TA and surround the transmission area TA. However, this is illustrated as an example, and the bezel area BZA of the window WP may be omitted. The window WP may include at least one functional layer among an anti-fingerprint layer, a hard coating layer, or an anti-reflection layer, and is not limited to any one embodiment.

The display module DM may be disposed below the window WP. The display module DM may be a component that substantially generates the image IM. The image IM generated by the display module DM may be displayed on a display surface IS of the display module DM, and may be externally visible to a user through the transmission area TA.

The display module DM may include a display area DA and a non-display area NDA. The display area DA may be an area that is activated in response to an electrical signal. The non-display area NDA may be adjacent to the display area DA. The non-display area NDA may surround the display area DA. The non-display area NDA may be an area covered by the bezel area BZA, and may not be visible from the outside.

The housing HAU may be coupled to the window WP. The housing HAU may be coupled to the window WP to provide a selected inner space. The display module DM may be accommodated in the inner space.

The housing HAU may include a material having relatively high rigidity. For example, the housing HAU may include a plurality of frames and/or plates, each of which includes glass, plastic or metal, or is made of a combination thereof. The housing HAU may stably protect components of the display module DM accommodated in the inner space from external impact.

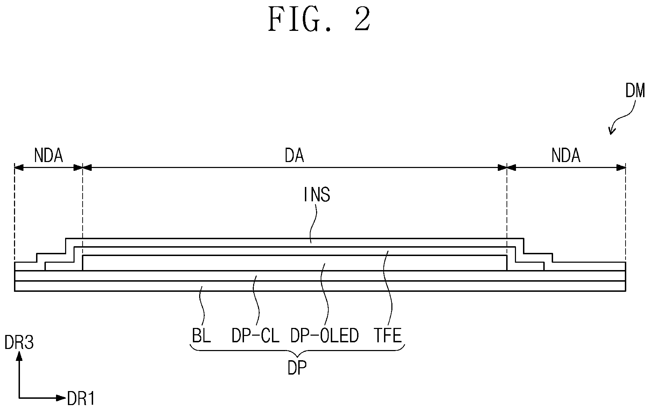

FIG. 2 is a schematic cross-sectional view of a display module according to an embodiment.

Referring to FIG. 2, a display module DM may include a display panel DP and an input sensor INS. For example, the display device DD (see FIG. 1A) according to an embodiment may further include a protective member disposed on a bottom surface of the display panel DP, or an anti-reflection member and/or a window member that are disposed on a top surface of the input sensor INS.

The display panel DP may be a light emitting display panel. However, this is an example, and the display panel DP is not limited thereto. For example, the display panel DP may be an organic light emitting display panel or an inorganic light emitting display panel. A light emitting layer in the organic light emitting display panel may include an organic light emitting material. A light emitting layer in the inorganic light emitting display panel may include a quantum dot, a quantum rod, or a micro LED. Hereinafter, the display panel DP is described as the organic light emitting display panel.

The display panel DP may include a base layer BL, and a circuit element layer DP-CL, a display element layer DP-OLED, and a thin-film encapsulation layer TFE that are disposed on the base layer BL. The input sensor INS may be disposed (directly disposed) on the thin-film encapsulation layer TFE. In the disclosure, "a component A being disposed directly on a component B" means that an adhesive layer is not disposed between the component A and the component B.

The base layer BL may include at least one plastic film. The base layer BL may be a flexible substrate and include a plastic substrate, a glass substrate, a metal substrate, an organic/inorganic composite material substrate, or the like. The same/similar display area DA and non-display area NDA as/to those described with reference to FIG. 1B may be defined in the base layer BL.

The circuit element layer DP-CL may include at least one insulation layer and a circuit element. The insulation layer may include at least one inorganic layer and at least one organic layer. The circuit element may include signal lines, a driving circuit of a pixel, and the like.

The display element layer DP-OLED may include a bank (or partition wall) and a light emitting element. The light emitting element may include an anode, an intermediate layer, and a cathode.

The thin-film encapsulation layer TFE may include a plurality of thin films. Some of the thin films may be disposed to improve optical efficiency, and some of the thin films may be disposed to protect organic light emitting diodes.

The input sensor INS may obtain coordinate information of an external input. The input sensor INS may have a multilayer structure. The input sensor INS may include a conductive layer having a single-layer structure or a multilayer structure. For example, the input sensor INS may include an insulation layer having a single-layer structure or a multilayer structure. The input sensor INS may detect an external input by using a capacitance method. However, this is an example, and embodiments are not limited thereto. For example, in an embodiment, the input sensor INS may detect an external input by using an electromagnetic induction method or a pressure detection method. In another embodiment, the input sensor INS may be omitted.

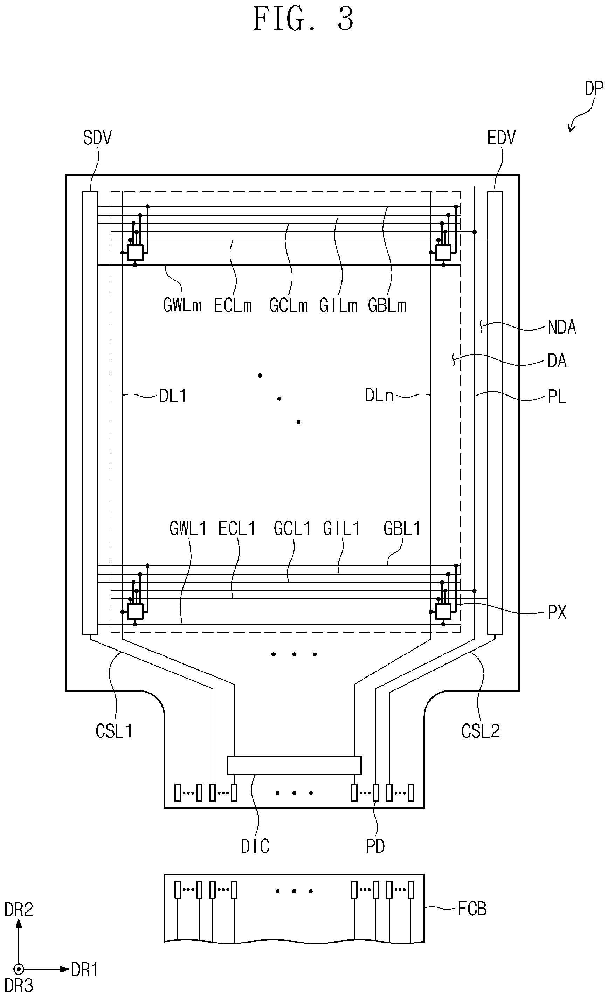

FIG. 3 is a schematic plan view of a display panel according to an embodiment.

Referring to FIG. 3, a display area DA, and a non-display area NDA around the display area DA may be defined in a display panel DP. The display area DA and the non-display area NDA may be divided according to whether a pixel PX is disposed or not. The pixel PX may be disposed in the display area DA. A scan driver SDV, a data driver, and an emission driver EDV may be disposed in the non-display area NDA. The data driver may be a partial circuit included in a driving chip DIC.

The display panel DP may include the pixels PX, initialization scan lines GIL1 to GILm, compensation scan lines GCL1 to GCLm, write scan lines GWL1 to GWLm, black scan lines GBL1 to GBLm, emission control lines ECL1 to ECLm, data lines DL1 to DLn, first and second control lines CSL1 and CSL2, a driving voltage line PL, and pads PD. For example, each of m and n is a natural number of 2 or more.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn, respectively.

The initialization scan lines GIL1 to GILm, the compensation scan lines GCL1 to GCLm, the write scan lines GWL1 to GWLm, and the black scan lines GBL1 to GBLm may extend in the first direction DR1 to be electrically connected to the scan driver SDV. The data lines DL1 to DLn may extend in the second direction DR2 to be electrically connected to the driving chip DIC. The emission control lines ECL1 to ECLm may extend in the first direction DR1 to be electrically connected to the emission driver EDV.

The driving voltage line PL may include a portion extending in the first direction DR1 and a portion extending in the second direction DR2. The portion extending in the first direction DR1 and the portion extending in the second direction DR2 may be disposed on different layers from each other. The driving voltage line PL may supply a driving voltage to each of the pixels PX.

The first control line CSL1 may be connected to the scan driver SDV. The second control line CSL2 may be connected to the emission driver EDV.

The driving chip DIC, the driving voltage line PL, the first control line CSL1, and the second control line CSL2 may be electrically connected to the pads PD. A flexible circuit film FCB may be electrically connected to the pads PD through an anisotropic conductive adhesive layer. The pads PD may be pads for connecting the flexible circuit film FCB to the display panel DP. The pads PD may be connected to corresponding pixels PX, respectively, through the driving voltage line PL, the first control line CSL1, and the second control line CSL2.

For example, the pads PD may further include input pads. The input pads may be pads for connecting the flexible circuit film FCB to the input sensor INS (see FIG. 2). However, embodiments are not limited thereto, and the input pads may be disposed in the input sensor INS (see FIG. 2) to be connected to a separate circuit board from the pads PD. In another example, the input sensor INS (see FIG. 2) may be omitted, and the pads PD may not further include input pads.

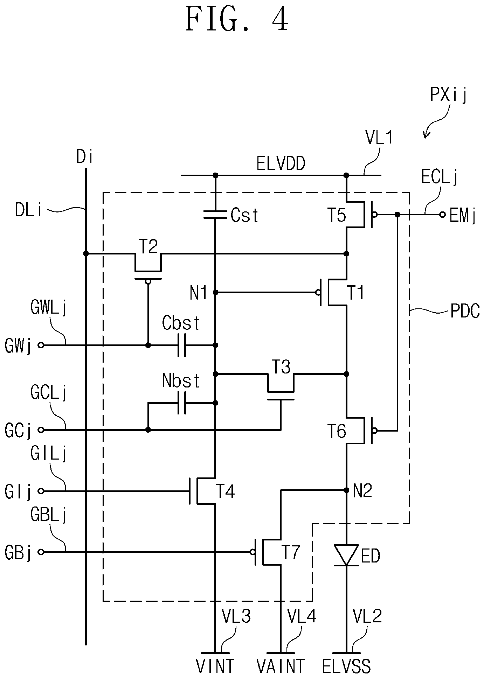

FIG. 4 is a schematic diagram of an equivalent circuit of a pixel according to an embodiment.

As an example, FIG. 4 illustrates an equivalent circuit of a pixel PXij of the pixels PX (see FIG. 3). Since the pixels PX (see FIG. 3) have the same circuit structure, the circuit structure of the pixel PXij will be described, and the specific description of the other pixels PX (see FIG. 3) will be omitted.

Referring to FIGS. 3 and 4, the pixel PXij may be connected to an i-th data line DLi of the data lines DL1 to DLn, a j-th initialization scan line GILj of the initialization scan lines GIL1 to GILm, a j-th compensation scan line GCLj of the compensation scan lines GCL1 to GCLm, a j-th write scan line GWLj of the write scan lines GWL1 to GWLm, a j-th black scan line GBLj of the black scan lines GBL1 to GBLm, a j-th emission control line ECLj of the emission control lines ECL1 to ECLm, first and second driving voltage lines VL1 and VL2, and first and second initialization voltage lines VL3 and VL4. For example, i may be an integer of 1 to n, and j may be an integer of 1 to m.

The pixel PXij may include a light emitting element ED and a pixel circuit PDC. The light emitting element ED may be a light emitting diode. As an example according to an embodiment, the light emitting element ED may be an organic light emitting diode including an organic light emitting layer, but embodiments are not limited thereto. The pixel circuit PDC may control an amount of current flowing through the light emitting element ED in response to a data signal Di. The light emitting element ED may emit light with selected luminance corresponding to the amount of current supplied from the pixel circuit PDC.

The pixel circuit PDC may include first to seventh transistors T1, T2, T3, T4, T5, T6 and T7, and first to third capacitors Cst, Cbst and Nbst. The configuration of the pixel circuit PDC according to an embodiment is not limited to the embodiment illustrated in FIG. 4. The pixel circuit PDC illustrated in FIG. 4 is just one example, and the configuration of the pixel circuit PDC may be modified and implemented.

At least one of the first to seventh transistors T1, T2, T3, T4, T5, T6 and T7 may be a transistor including a low-temperature polycrystalline silicon (LTPS) semiconductor layer. At least one of the first to seventh transistors T1, T2, T3, T4, T5, T6 and T7 may be a transistor including an oxide semiconductor layer. For example, the third and fourth transistors T3 and T4 may be oxide semiconductor transistors, and the first, second, fifth, sixth, and seventh transistors T1, T2, T5, T6 and T7 may be LTPS transistors.

For example, the first transistor T1 that directly affects the brightness of the light emitting element ED may include a semiconductor layer made of a polycrystalline silicon having high reliability, thereby implementing a display device having a high resolution. As an oxide semiconductor has high carrier mobility and low leak current, voltage drop may not be great although a driving time is long. For example, a change in color of an image due to voltage drop may not be great even during low-frequency driving, and thus low-frequency driving may be enabled. As the oxide semiconductor has the advantage of low leak current as above, at least one of the third transistor T3 or the fourth transistor T4, each of which is connected to a gate electrode of the first transistor T1, may be implemented as the oxide semiconductor to prevent leak current likely to flow to the gate electrode, and also reduce power consumption.

Some of the first to seventh transistors T1, T2, T3, T4, T5, T6 and T7 may be p-type transistors, and some of the others may be n-type transistors. For example, the first, second, fifth, sixth, and seventh transistors T1, T2, T5, T6 and T7 may be p-type transistors, and the third and fourth transistors T3 and T4 may be n-type transistors.

The configuration of the pixel circuit PDC according to an embodiment is not limited to the embodiment illustrated in FIG. 4. The pixel circuit PDC illustrated in FIG. 4 is just an example, and the configuration of the pixel circuit PDC may be modified and implemented. For example, all of the first to seventh transistors T1, T2, T3, T4, T5, T6 and T7 may be either p-type transistors or n-type transistors. In another example, the first, second, fifth, and sixth transistors T1, T2, T5 and T6 may be p-type transistors, and the third, fourth, and seventh transistors T3, T4 and T7 may be n-type transistors.

The j-th initialization scan line GILj, the j-th compensation scan line GCLj, the j-th write scan line GWLj, the j-th black scan line GBLj, and the j-th emission control line ECLj may transmit, to the pixel PXij, a j-th initialization scan signal GIj, a j-th compensation scan signal GCj, a j-th write scan line signal GWj, a jth black scan signal GBj, and a j-th emission control signal EMj, respectively. The i-th data line DLi transmits an i-th data signal Di to the pixel PXij. The i-th data signal Di may have a voltage level corresponding to an image signal input to the display device DD (see FIGS. 1A and 1B).

The first and second driving voltage lines VL1 and VL2 may transmit, to the pixel PXij, a first driving voltage ELVDD and a second driving voltage ELVSS, respectively. For example, the first and second initialization voltage lines VL3 and VL4 may transmit, to the pixel PXij, a first initialization voltage VINT and a second initialization voltage VAINT, respectively.

The first transistor T1 may be connected between the first driving voltage line VL1, which receives the first driving voltage ELVDD, and the light emitting element ED. The first transistor T1 may include a first electrode connected to the first driving voltage line VL1 via the fifth transistor T5, a second electrode connected to a pixel electrode (or referred to as an anode) of the light emitting element ED via the sixth transistor T6, and a third electrode (e.g., gate electrode) connected to an end (e.g., first node N1) of the first capacitor Cst. The first transistor T1 may receive the i-th data signal Di transmitted by the i-th data line DLi according to a switching operation of the second transistor T2, and then supply driving current to the light emitting element ED.

The second transistor T2 may be connected between the data line DLi and the first electrode of the first transistor T1. The second transistor T2 may include a first electrode connected to the data line DLi, a second electrode connected to the first electrode of the first transistor T1, and a third electrode (e.g., gate electrode) connected to the j-th write scan line GWLj. The second transistor T2 may be turned on in response to the write scan line signal GWj received through the j-th write scan line GWLj, and then transmit the i-th data signal Di received from the i-th data line DLi to the first electrode of the first transistor T1. The second capacitor Cbst may have an end portion connected to the third electrode of the second transistor T2, and another end portion connected to the first node N1.

The third transistor T3 may be connected between the second electrode of the first transistor T1 and the first node N1. The third transistor T3 may include a first electrode connected to the third electrode of the first transistor T1, a second electrode connected to the second electrode of the first transistor T1, and a third electrode (e.g., gate electrode) connected to the j-th compensation scan line GCLj. The third transistor T3 may be turned on in response to the j-th compensation scan signal GCj received through the j-th compensation scan line GCLj, and then connect the third electrode of the first transistor T1 and the second electrode of the first transistor T1 to each other so that the first transistor T1 may be diode-connected. The third capacitor Nbst may have an end portion connected to the third electrode of the third transistor T3, and another end portion connected to the first node N1.

The fourth transistor T4 may be connected between the first initialization voltage line VL3, to which the first initialization voltage VINT is applied, and the first node N1. The fourth transistor T4 may include a first electrode connected to the first initialization voltage line VL3 to which the first initialization voltage VINT is transmitted, a second electrode connected to the first node N1, and a third electrode (e.g., gate electrode) connected to the j-th initialization scan line GILj. The fourth transistor T4 may be turned on in response to the j-th initialization scan signal GIj received through the j-th initialization scan line GILj. The turned-on fourth transistor T4 transmits the first initialization voltage VINT to the first node N1 to initialize a potential of the third electrode (i.e., potential of the first node N1) of the first transistor T1.

The fifth transistor T5 may include a first electrode connected to the first driving voltage line VL1, a second electrode connected to the first electrode of the first transistor T1, and a third electrode (e.g., gate electrode) connected to the j-th emission control line ECLj. The sixth transistor T6 may include a first electrode connected to the second electrode of the first transistor T1, a second electrode connected to the pixel electrode of the light emitting element ED, and a third electrode (e.g., gate electrode) connected to the j-th emission control line ECLj.

The fifth and sixth transistors T5 and T6 may be turned on at the same time in response to the j-th emission control signal EMj received through the j-th emission control line ECLj. The first driving voltage ELVDD applied through the turned-on fifth transistor T5 may be compensated through the diode-connected first transistor T1, and then transmitted to the light emitting element ED through the sixth transistor T6.

The seventh transistor T7 may include a first electrode connected to the second initialization voltage line VL4 to which the second initialization voltage VAINT is transmitted, a second electrode connected to the second electrode of the sixth transistor T6 (or second node N2), and a third electrode (e.g., gate electrode) connected to the black scan line GBLj. The second initialization voltage VAINT may have a voltage level that is less than or equal to that of the first initialization voltage VINT.

The first capacitor Cst may have an end portion connected to the third electrode of the first transistor T1, and the other end connected to the first driving voltage line VL1. A cathode of the light emitting element ED may be connected to the second driving voltage line VL2 that transmits the second driving voltage ELVSS. The second driving voltage ELVSS may have a voltage level that is less than that of the first driving voltage ELVDD.

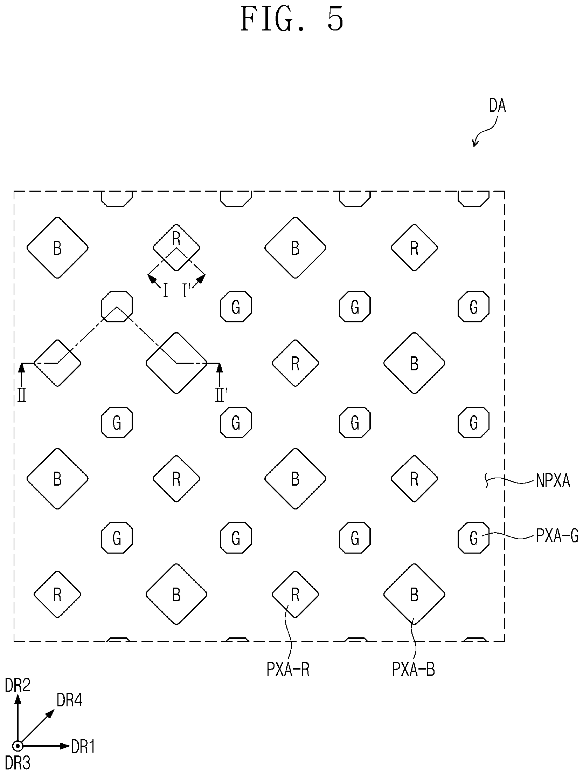

FIG. 5 is an enlarged schematic plan view of a portion of a display area of a display panel according to an embodiment. FIG. 5 illustrates a plane of a display module when viewed on a display surface of the display module, and illustrates arrangement of light emitting areas.

Referring to FIG. 5, a display area DA may include first to third light emitting areas PXA-R, PXA-G and PXA-B, and a peripheral area NPXA surrounding the first to third light emitting areas PXA-R, PXA-G and PXA-B. The first to third light emitting areas PXA-R, PXA-G and PXA-B may correspond respectively to areas on which light provided from light emitting elements is emitted. The first to third light emitting areas PXA-R, PXA-G and PXA-B may be divided according to colors of light emitted toward the outside of the display module DM (see FIG. 2).

The first to third light emitting areas PXA-R, PXA-G and PXA-B may provide light having first to third colors different from each other, respectively. For example, the light having the first color may be red light, the light having the second color may be green light, and the light having the third color may be blue light. However, examples of the light having the first to third colors are not limited to the foregoing examples.

Each of the first to third light emitting areas PXA-R, PXA-G and PXA-B may be defined as an area in which a top surface of an anode is exposed by a light emitting opening portion to be described later. The peripheral area NPXA may set a boundary of each of the first to third light emitting areas PXA-R, PXA-G and PXA-B, and prevent mixture of colors between the first to third light emitting areas PXA-R, PXA-G and PXA-B.

Each of the first to third light emitting areas PXA-R, PXA-G and PXA-B may be formed in plurality to have a selected arrangement shape and be repeatedly disposed within the display area DA. For example, the first and third light emitting areas PXA-R and PXA-B may be alternately arranged in the first direction DR1 to constitute a "first group." The second light emitting areas PXA-G may be arranged in the first direction DR1 to constitute a "second group." Each of the "first group" and the "second group" may be provided in plurality, and the "first groups" and the "second groups" may be alternately arranged in the second direction DR2.

One second light emitting area PXA-G may be disposed to be spaced apart from one first light emitting area PXA-R or one third light emitting area PXA-B in a fourth direction DR4. The fourth direction DR4 may be defined as a direction between the first and second directions DR1 and DR2.

FIG. 5 illustrates an example of the arrangement shape of the first to third light emitting areas PXA-R, PXA-G and PXA-B. However, embodiments are not limited thereto, and the first to third light emitting areas PXA-R, PXA-G and PXA-B may be arranged in various shapes. In an embodiment, the first to third light emitting areas PXA-R, PXA-G and PXA-B may have a PENTILE^{™} arrangement shape as illustrated in FIG. 5. In another example, the first to third light emitting areas PXA-R, PXA-G and PXA-B may have a stripe arrangement shape or a diamond (Diamond Pixel^{™}) arrangement shape.

Each of the first to third light emitting areas PXA-R, PXA-G and PXA-B may have various shapes in plan view. For example, each of the first to third light emitting areas PXA-R, PXA-G and PXA-B may have a shape such as a polygonal, circular, or oval shape. As an example, FIG. 5 illustrates the first and third light emitting areas PXA-R and PXA-B each having a square (or rhombus) shape and the second light emitting area PXA-G having an octagonal shape in plan view.

The first to third light emitting areas PXA-R, PXA-G and PXA-B may have the same shape, or at least some thereof may have different shapes from each other in plan view. As an example, FIG. 5 illustrates the first and third light emitting areas PXA-R and PXA-B having the same shape, and the second light emitting area PXA-G having a different shape from the first and third light emitting areas PXA-R and PXA-B in plan view.

At least some of the first to third light emitting areas PXA-R, PXA-G and PXA-B may have different surface areas in plan view. In an embodiment, a surface area of the first light emitting area PXA-R that emits the red light may be greater than a surface area of the second light emitting area PXA-G that emits the green light, and be less than a surface area of the third light emitting area PXA-B that emits the blue light. However, a large-small relationship between the surface areas of the first to third light emitting areas PXA-R, PXA-G and PXA-B according to the colors of the emitted light is not limited thereto, and may be varied according to design of the display module DM (see FIG. 2). However, embodiments are not limited thereto, and the first to third light emitting areas PXA-R, PXA-G and PXA-B may have the same surface area in plan view.

The shape, surface area, arrangement, and the like of the first to third light emitting areas PXA-R, PXA-G and PXA-B of the display module DM (see FIG. 2) according to an embodiment may be variously designed according to the color of the emitted light or the size or configuration of the display module DM (see FIG. 2), and are not limited to the embodiment illustrated in FIG. 5.

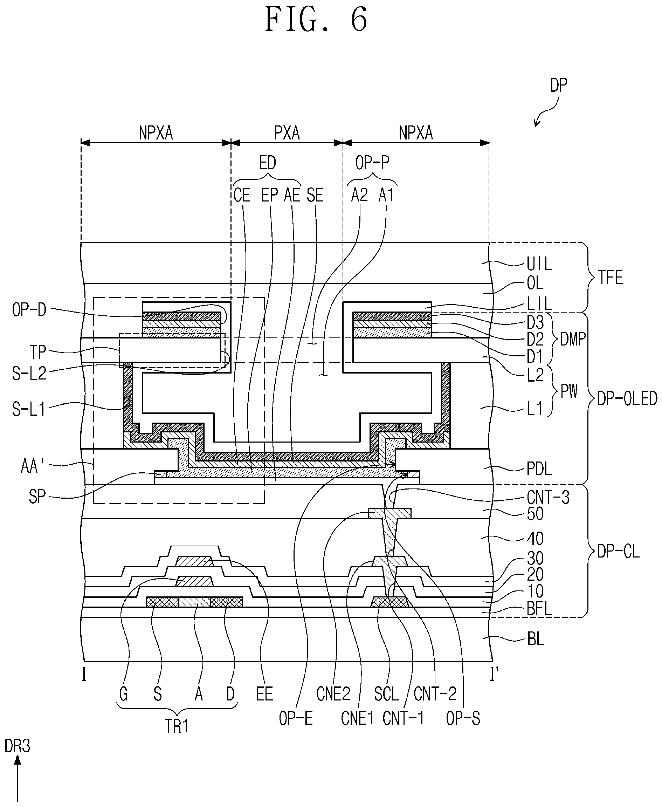

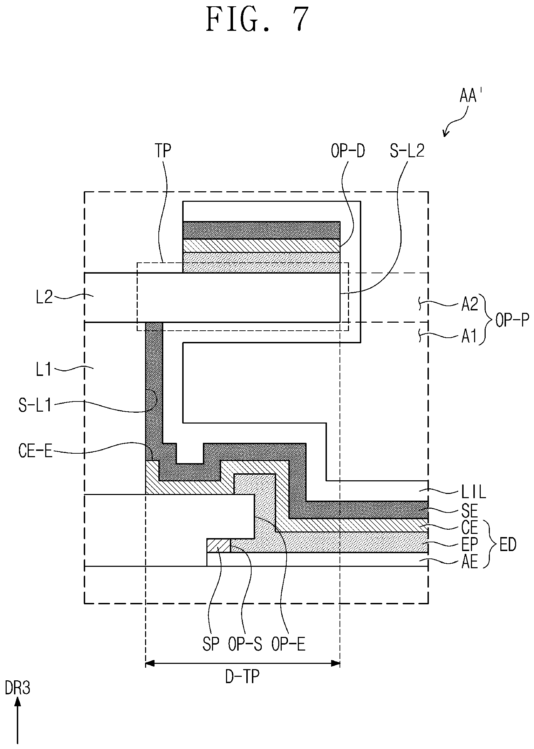

FIG. 6 is a schematic cross-sectional view of a portion of a display panel according to an embodiment. FIG. 7 is an enlarged schematic view of a portion of a display panel according to an embodiment. FIG. 6 is a schematic cross-sectional view, which is taken along line I-I' in FIG. 5, of the display panel according to an embodiment, and FIG. 7 is an enlarged schematic view illustrating area AA' in FIG. 6. In an embodiment to be described with reference to FIGS. 6 and 7, FIG. 5 is referred to, and components designated by like reference numbers or symbols are not described.

FIG. 6 illustrates an enlarged schematic view of one light emitting area PXA in the display area DA (see FIG. 5), and the light emitting area PXA in FIG. 6 may correspond to any one of the first to third light emitting areas PXA-R, PXA-G and PXA-B in FIG. 5.

Referring to FIG. 6, a display panel DP may include a base layer BL, a circuit element layer DP-CL, a display element layer DP-OLED, and a thin-film encapsulation layer TFE.

The display panel DP may include insulation layers, a semiconductor pattern, a conductive pattern, a signal line, and the like. The insulation layers, the semiconductor layer, and the conductive layer may be formed by a coating process, a deposition process, or the like. Thereafter, the insulation layers, the semiconductor layer, and the conductive layer may be selectively patterned by a photolithography process and an etching process. The semiconductor pattern, the conductive pattern, and the signal line, and the like, which are included in the circuit element layer DP-CL and the display element layer DP-OLED, may be formed by those processes.

The circuit element layer DP-CL may be disposed on the base layer BL. The circuit element layer DP-CL may include a buffer layer BFL, a transistor TR1, a signal transmission area SCL, first to fifth insulation layers 10, 20, 30, 40 and 50, an electrode EE, and connection electrodes CNE1 and CNE2.

The buffer layer BFL may be disposed on the base layer BL. The buffer layer BFL may improve bonding force between the base layer BL and the semiconductor pattern. The buffer layer BFL may include a silicon oxide layer and a silicon nitride layer. The silicon oxide layer and the silicon nitride layer may be alternately stacked with each other.

The semiconductor pattern may be disposed on the buffer layer BFL. The semiconductor pattern may include polysilicon. However, embodiments are not limited thereto, and the semiconductor pattern may include amorphous silicon or a metal oxide. FIG. 6 just illustrates a portion of the semiconductor pattern, and the semiconductor pattern may be further disposed in the light emitting areas PXA-R, PXA-G and PXA-B (see FIG. 5). The semiconductor pattern may be arranged over the light emitting areas PXA-R, PXA-G and PXA-B (see FIG. 5) according to a specific rule. The semiconductor pattern may have different electrical properties according to whether or not the semiconductor pattern is doped. The semiconductor pattern may include a first region having a high doping concentration and a second region having a low doping concentration. The first region may be doped with an n-type dopant or a p-type dopant. A p-type transistor may include the first region doped with the p-type dopant.

The first region may have higher conductivity than the second region, and may substantially function as an electrode or a signal line. The second region may substantially correspond to an active (or channel) of a transistor. For example, a portion of the semiconductor pattern may be an active of the transistor, another portion thereof may be a source or a drain of the transistor, and still another portion thereof may be a conductive region.

A source S, an active A, and a drain D of the transistor TR1 may be provided from the semiconductor pattern. FIG. 6 illustrates a portion of the signal transmission area SCL provided from the semiconductor pattern. For example, the signal transmission area SCL may be connected to the drain D of the transistor TR1 in plan view.

The first to fifth insulation layers 10 to 50 may be disposed on the buffer layer BFL. Each of the first to fifth insulation layers 10 to 50 may be an inorganic layer or an organic layer.

The first insulation layer 10 may be disposed on the buffer layer BFL. A gate G may be disposed on the first insulation layer 10. The second insulation layer 20 may be disposed on the first insulation layer 10 to cover the gate G. The electrode EE may be disposed on the second insulation layer 20. The third insulation layer 30 may be disposed on the second insulation layer 20 to cover the electrode EE.

A first connection electrode CNE1 may be disposed on the third insulation layer 30. The first connection electrode CNE1 may be connected to the signal transmission area SCL through a contact hole CNT-1 passing through the first to third insulation layers 10 to 30. The fourth insulation layer 40 may be disposed on the third insulation layer 30 to cover the first connection electrode CNE1. The fourth insulation layer 40 may be an organic layer.

A second connection electrode CNE2 may be disposed on the fourth insulation layer 40. The second connection electrode CNE2 may be connected to the first connection electrode CNE1 through a contact hole CNT-2 passing through the fourth insulation layer 40. The fifth insulation layer 50 may be disposed on the fourth insulation layer 40 to cover the second connection electrode CNE2. The fifth insulation layer 50 may be an organic layer.

The display element layer DP-OLED may be disposed on the circuit element layer DP-CL. The display element layer DP-OLED may include a light emitting element ED, a pixel defining film PDL, a bank (or partition wall) PW, and a dummy pattern DMP.

In an embodiment, the light emitting element ED may include an anode AE (or first electrode), a conductive pattern, a light emitting pattern EP, and a cathode CE (or second electrode).

The anode AE may be disposed on the fifth insulation layer 50 of the circuit element layer DP-CL. The anode AE may be a transmissive electrode, a semi-transmissive electrode, or a reflective electrode. The anode AE may have conductivity. For example, the anode AE may be made of various materials such as a metal, a transparent conductive oxide (TCO), or a conductive polymeric material, as long as the anode AE is capable of having conductivity. The anode AE may have a single-layer structure, or have a multilayer structure.

In an embodiment, the anode AE may include three layers that include an indium tin oxide (ITO), silver (Ag), and an indium tin oxide (ITO), respectively. The anode AE may be connected to the second connection electrode CNE2 through a connection contact hole CNT-3 passing through and defined (or formed) in the fifth insulation layer 50. Thus, the anode AE may be electrically connected to the signal transmission area SCL through the first and second connection electrodes CNE1 and CNE2, and be electrically connected to a corresponding circuit element.

According to an embodiment, the display panel DP may further include a sacrificial pattern SP. The sacrificial pattern SP may be disposed between the anode AE and the pixel defining film PDL. A sacrificial opening portion OP-S that exposes a portion of a top surface of the anode AE may be defined (or formed) in the sacrificial pattern SP. The sacrificial opening portion OP-S may overlap a light emitting opening portion OP-E to be described later.

The pixel defining film PDL may be disposed on the fifth insulation layer 50 of the circuit element layer DP-CL. The light emitting opening portion OP-E may be defined (or formed) in the pixel defining film PDL. The light emitting opening portion OP-E may correspond to the anode AE, and the pixel defining film PDL may expose at least a portion of the anode AE through the light emitting opening portion OP-E.

For example, the light emitting opening portion OP-E may correspond to the sacrificial opening portion OP-S of the sacrificial pattern SP. According to an embodiment, the top surface of the anode AE may be spaced apart from the pixel defining film PDL with the sacrificial pattern SP therebetween on a cross-section, and accordingly, the anode AE may be protected from damage in a process of forming the light emitting opening portion OP-E.

A width of the light emitting opening portion OP-E in a direction may be less than a width of the sacrificial opening portion OP-S in the direction. The direction used herein may mean a direction perpendicular to a thickness direction (i.e., third direction DR3) of the display panel DP. An inner side surface of the pixel defining film PDL, which defines the light emitting opening portion OP-E, may be more adjacent (or closer) to a center portion of the anode AE than an inner side surface of the sacrificial pattern SP, which defines the sacrificial opening portion OP-S. However, embodiments are not limited thereto, and the inner side surface of the sacrificial pattern SP, which defines the sacrificial opening portion OP-S, may be substantially aligned with the inner side surface of the pixel defining film PDL, which defines a corresponding light emitting opening portion OP-E. For example, the light emitting area may be considered to be an area of the anode AE that is exposed from a corresponding sacrificial opening portion OP-S. In another example, the sacrificial pattern SP may be omitted.

The pixel defining film PDL may include an inorganic insulation material. For example, the pixel defining film PDL may include a silicon nitride (SiNₓ). The pixel defining film PDL may be disposed between the anode AE and the bank PW to block an electrical connection between the anode AE and the bank PW.

The bank PW may be disposed on the pixel defining film PDL. A bank opening portion (or partition wall opening portion) OP-P may be defined (or formed) in the bank PW. The bank opening portion OP-P may overlap the light emitting opening portion OP-E, and expose at least a portion of the anode AE.

The bank PW may have an undercut shape on a cross-section. The bank PW may include a plurality of layers stacked in sequence, and at least one of the plurality of layers may be recessed from the layers stacked to be adjacent thereto. Accordingly, the bank PW may include a tip part TP.

In an embodiment, the bank PW may include a first bank layer (or first partition wall layer) L1 and a second bank layer (or second partition wall layer) L2. The first bank layer L1 may be disposed on the pixel defining film PDL, and the second bank layer L2 may be disposed on the first bank layer L1. As illustrated in FIG. 6, the first bank layer L1 may have a thickness that is greater than a thickness of the second bank layer L2, but embodiments are not limited thereto. The drawing illustrates only a state of the bank PW in which the first bank layer L1 and the second bank layer L2 are disposed, but embodiments are not limited thereto. For example, a third bank layer may be disposed on the second bank layer L2, and the bank PW is not limited to any one embodiment. For example, the third bank layer may have a thickness that is greater than the thickness of the second bank layer L2, but embodiments are not limited thereto.

The bank opening portion OP-P defined (or formed) in the bank PW may include a first area A1 and a second area A2. The first bank layer L1 may have a first inner side surface S-L1 that defines the first area A1 of the bank opening portion OP-P. The second bank layer L2 may have a second inner side surface S-L2 that defines the second area A2. The second inner side surface S-L2 of the second bank layer L2 may be more adjacent (or closer) to the center portion of the anode AE than the first inner side surface S-L1 of the first bank layer L1 on a cross-section. The first inner side surface S-L1 may be recessed from the second inner side surface S-L2 in a direction that is away from the center portion of the anode AE.

The first area A1 may have a width that is different from a width of the second area A2. The width of the first area A1 may be greater than the width of the second area A2. For example, the second area A2 of the bank opening portion OP-P may be an area that defines the tip part TP. For example, the light emitting area PXA may be considered to be an area of the anode AE, which is exposed from the second area A2 of the bank PW that corresponds thereto.

The first bank layer L1 may have conductivity. The first bank layer L1 may include a conductive material. For example, the conductive material may include a metal, a metal nitride, a transparent conductive oxide (TCO), or a combination thereof. For example, the metal may include gold (Au), silver (Ag), aluminium (Al), magnesium (Mg), lithium (Li), molybdenum (Mo), titanium (Ti), copper (Cu), or an alloy. The metal nitride may include a titanium nitride (TiN). The transparent conductive oxide may include an indium tin oxide (ITO), an indium zinc oxide (IZO), a zinc oxide, an indium oxide, an indium gallium oxide, an indium gallium zinc oxide (IGZO), or an aluminium zinc oxide.

The second bank layer L2 may be disposed on the first bank layer L1. The second bank layer L2 may include a material having different etch selectivity from that of the first bank layer L1. As an example, the second bank layer L2 may have reactivity to an etchant that is lower than reactivity of the first bank layer L1.

In an embodiment, the first bank layer L1 may be recessed relative to the second bank layer L2 with respect to the light emitting area. For example, the first bank layer L1 may be undercut relative to the second bank layer L2. A portion, which protrudes from the first bank layer L1 toward the light emitting area, of the second bank layer L2 by a protruding length D-TP (in FIG. 7) may define (or form) the tip part TP in the bank PW.

The second bank layer L2 may include a conductive material. For example, the conductive material may include a metal, a metal nitride, a transparent conductive oxide (TCO), or a combination thereof. For example, the metal may include gold (Au), silver (Ag), aluminium (Al), magnesium (Mg), lithium (Li), molybdenum (Mo), titanium (Ti), copper (Cu), or an alloy. The metal nitride may include a titanium nitride (TiN). The transparent conductive oxide may include an indium tin oxide (ITO), an indium zinc oxide (IZO), a zinc oxide, an indium oxide, an indium gallium oxide, an indium gallium zinc oxide (IGZO), or an aluminium zinc oxide.

In another embodiment, the second bank layer L2 may include an insulation material. For example, the second bank layer L2 may include an inorganic insulation material, and may include, for example, a silicon nitride (SiNₓ) or a silicon oxide (SiOₓ). However, this is illustrated as an example, and the second bank layer L2 may be omitted in the bank PW according to an embodiment.

In an embodiment, the second inner side surface S-L2 of the second bank layer L2 may be more adjacent (or closer) to the center portion of the anode AE than the first inner side surface S-L1 of the first bank layer L1. For example, the first inner side surface S-L1 of the first bank layer L1 may be disposed to be recessed from the second inner side surface S-L2 of the second bank layer L2 in a direction that is away from the center portion of the anode AE. Accordingly, the second bank layer L2 may have a bottom surface exposed from the first bank layer L1.

The bank PW may have an undercut shape on a cross-section. As described above, the undercut shape of the bank PW may be defined by a stepped portion between the first inner side surface S-L1 of the first bank layer L1 and the second inner side surface S-L2 of the second bank layer L2. The shape of the bank PW on a cross-section is not limited thereto. For example, the bank PW may have various shapes such as reverse tapered shape or overhang, and is not limited to any one embodiment.

FIG. 6 illustrates an example in which each of the first inner side surface S-L1 of the first bank layer L1 and the second inner side surface S-L2 of the second bank layer L2 is perpendicular to a top surface of the fifth insulation layer 50. However, embodiments are not limited thereto.

The light emitting pattern EP may be disposed on the anode AE. The light emitting pattern EP may be patterned by each of the tip parts TP defined (or formed) in the bank PW. At least a portion of the light emitting pattern EP may be disposed in the light emitting opening portion OP-E. The entirety of the light emitting pattern EP may be disposed in the light emitting opening portion OP-E, and the light emitting pattern EP may be disposed not only in each of the light emitting opening portions OP-E but also in the bank opening portions OP-P. In an embodiment in which the sacrificial pattern SP is included, the light emitting pattern EP may be disposed also in the sacrificial opening portion.

The light emitting pattern EP may include a light emitting layer including a light emitting material. The light emitting pattern EP may further include a hole injection layer (HIL) and a hole transport layer (HTL), which are disposed between the anode AE and the light emitting layer, and may further include an electron transport layer (ETL) and an electron injection layer (EIL), which are disposed on the light emitting layer. The light emitting pattern EP may be referred to as an "organic layer" or an "intermediate layer."

The cathode CE may be disposed on the light emitting pattern EP. The cathode CE may be patterned by each of the tip parts TP defined (or formed) in the bank PW. At least a portion of the cathode CE may be disposed in the bank opening portion OP-P. In an embodiment, a portion of the cathode CE may be disposed also in the light emitting opening portion OP-E according to the thickness of the light emitting pattern EP or the thickness of the pixel defining film PDL.

The cathode CE may have conductivity. For example, the cathode CE may be made of various materials such as a metal, a transparent conductive oxide (TCO), or a conductive polymeric material, as long as the cathode CE is capable of having conductivity.

FIG. 6 illustrates a case in which an end portion of the cathode CE is in contact with the bank PW, but embodiments are not limited thereto. For example, the end portion of the cathode CE may be spaced apart from the bank PW, and is not limited to any one embodiment.

An auxiliary electrode SE may be disposed on the light emitting element ED. For example, the auxiliary electrode SE may be disposed on the cathode CE. A portion of the auxiliary electrode SE may be disposed in the bank opening portion OP-P. The auxiliary electrode SE may extend along the first inner side surface S-L1 of the first bank layer L1. For example, the auxiliary electrode SE may be in contact with the first inner side surface S-L1 of the first bank layer L1 to extend. The auxiliary electrode SE may cover end portions (e.g., opposite end portions) of the light emitting pattern EP and end portions (e.g., opposite end portions) of the cathode CE.

The auxiliary electrode SE may be in contact with the first inner side surface S-L1 of the first bank layer L1, and be in contact with the cathode CE. For example, the auxiliary electrode SE may be electrically connected to the bank PW and the cathode CE. The bank PW may receive the second driving voltage ELVSS (see FIG. 4), and the auxiliary electrode SE may be electrically connected to the bank PW to receive the second driving voltage ELVSS (see FIG. 4). Accordingly, the cathode CE electrically connected to the auxiliary electrode SE may receive the second driving voltage ELVSS.

Referring to the drawings, the auxiliary electrode SE may extend via the end portion of the cathode CE to be in contact with the first inner side surface S-L1 of the first bank layer L1. The drawing illustrates a state in which the cathode CE is in contact with the first inner side surface S-L1 of the first bank layer L1, the auxiliary electrode SE extends via the end portion CE-E of the cathode CE to be in contact with the first inner side surface S-L1 of the first bank layer L1. However, embodiments are not limited thereto. For example, in a state in which the cathode CE is spaced apart from the first inner side surface S-L1 of the first bank layer L1, the auxiliary electrode SE may also extend via the end portion of the cathode CE to be in contact with the first inner side surface S-L1 of the first bank layer L1, and is not limited to any one embodiment.

The auxiliary electrode SE may have a higher step coverage than the cathode CE. A size of an area on which the auxiliary electrode SE is in contact with the first inner side surface S-L1 of the first bank layer L1 may be larger than a size of an area on which the cathode CE is in contact with the first inner side surface S-L1 of the first bank layer L1. For example, a degree at which the auxiliary electrode SE extends along the first inner side surface S-L1 to be in contact with the first inner side surface S-L1 may be greater than a degree at which the cathode CE extends along the first inner side surface S-L1 to be in contact with the first inner side surface S-L1. For example, the auxiliary electrode SE may also be in contact with the second bank layer L2 unlike the cathode CE.

The auxiliary electrode SE may have a thickness of about 100 angstrom (Å) to about 1,000 angstrom (Å). In another example, the auxiliary electrode SE may have a thickness of about 100 angstrom (Å) to about 650 angstrom (Å).

The auxiliary electrode SE may be formed in an amorphous structure. Accordingly, etching of the auxiliary electrode SE may be readily performed in a wet etching process to be described later.

The auxiliary electrode SE may have conductivity. According to an embodiment, the cathode CE may be electrically connected to the bank PW through the auxiliary electrode SE without being in direct contact with the bank PW. Each of adhesion between the auxiliary electrode SE and the cathode CE and adhesion between the auxiliary electrode SE and the bank PW may be greater than adhesion between the cathode CE and the bank PW. Accordingly, a phenomenon in which foreign matters penetrate into the display element layer DP-OLED may be eliminated. This may prevent the light emitting element ED from being damaged in a process performed after the auxiliary electrode SE is deposited, may provide the display element layer DP-OLED having high durability, and may improve lifetime of the display panel DP.

For example, the cathode CE and the bank PW may be stably in contact with each other, and even in a state in which the cathode CE and the bank PW are not in contact with each other, an electrical connection between the cathode CE and the bank PW may be reliably established to enhance the stability and reliability of the electrical connection between the cathode CE and the bank PW. Accordingly, the display element layer DP-OLED may have high durability, and the lifetime of the display panel DP may be improved.

For example, the cathode CE may include silver (Ag), and the bank PW may include aluminium (Al). As a process is performed, an oxide film may be generated on aluminium (Al) of the bank PW. For example, the auxiliary electrode SE may include a transparent conductive oxide (TCO) to have higher adhesion to the bank PW than to the cathode CE.

The auxiliary electrode SE may have a refractive index that is less than or equal to a refractive index of the thin-film encapsulation layer TFE to be described later. In another example, the auxiliary electrode SE may have a refractive index that is less than or equal to a refractive index of a lower inorganic encapsulation pattern LIL to be described later. As the auxiliary electrode SE has the refractive index that is less than or equal to the refractive index of the thin-film encapsulation layer TFE, an interference to a traveling direction (or transmitting direction) of light may be prevented from occurring between the auxiliary electrode SE and the thin-film encapsulation layer TFE. For example, occurrence of the interference to a traveling direction of light between the auxiliary electrode SE and the thin-film encapsulation layer TFE may be prevented such that light transmittance characteristics of the light emitting area PXA may be prevented from deteriorating.

As an example, in the case that the lower inorganic encapsulation pattern LIL includes a silicon nitride (SiNₓ) to have a refractive index of about 1.9, the refractive index of the auxiliary electrode SE may be about 1.9 or less in a wavelength range of 380 nm to 760 nm. For example, the refractive index of the auxiliary electrode SE may be about 1.76 to about 1.89 in a wavelength range of 380 nm to 760 nm. A wavelength range of 380 nm to 760 nm may be the visible light wavelength range. For example, the refractive index of the auxiliary electrode SE may be about 1.9 or less in a wavelength 550 nm, but embodiments are not limited thereto. For example, the refractive index of the auxiliary electrode SE may be about 1.8 or less, or be the same as the refractive index of the encapsulation layer TFE, and is not limited to any one embodiment.

The auxiliary electrode SE may include a transparent conductive oxide (TCO). The auxiliary electrode SE may include an indium tin oxide (ITO). The auxiliary electrode SE may include an indium tin oxide (ITO) doped with a group 2 element. For example, the group 2 element may be magnesium (Mg) or calcium (Ca), but embodiments are not limited thereto. For example, the group 2 element may include another group 2 element, and is not limited to any one embodiment. For example, the auxiliary electrode SE may be doped with a plurality of group 2 elements that are different from each other. As an example, the auxiliary electrode SE may be doped with both magnesium (Mg) and calcium (Ca), and is not limited to any one embodiment.

The auxiliary electrode SE may include an indium tin oxide (ITO) in which a content of a group 2 element is about 1 at% to about 5 at%. In another example, the content of the group 2 element relative to the indium tin oxide (ITO) is about 1 at% to about 3 at%. As the content of the group 2 element in the auxiliary electrode SE is about 1 at% to about 5 at%, the refractive index of the auxiliary electrode SE may be about 1.76 to about 1.89. For example, as the content of the group 2 element in the auxiliary electrode SE is about 1 at% to about 3 at%, resistance may be prevented from rapidly increasing during the electrical connection between the auxiliary electrode SE and the bank PW. For example, the refractive index of the auxiliary electrode SE may be less than or equal to the refractive index of the encapsulation layer TFE as described above.

According to an embodiment, the display panel DP may further include a capping pattern. The capping pattern may be disposed on the cathode CE. The capping pattern may be patterned by the tip part TP defined (or formed) in the bank PW. At least a portion of the capping pattern may be disposed in the bank opening portion OP-P.

The dummy pattern DMP may be disposed on the bank PW. The dummy pattern DMP may include a first dummy pattern D1, a second dummy pattern D2, and a third dummy pattern D3. The first to third dummy patterns D1, D2 and D3 may be stacked in sequence on the top surface of the second bank layer L2 of the bank PW in the third direction DR3.

The first dummy pattern D1 may include an organic material. For example, the first dummy pattern D1 and the light emitting pattern EP may include the same material as each other. The first dummy pattern D1 may be formed simultaneously with the light emitting pattern EP by a single process, and then be separated from the light emitting pattern EP due to the undercut shape of the bank PW.

The second dummy pattern D2 may include a conductive material. For example, the second dummy pattern D2 and the cathode CE may include the same material as each other. The second dummy pattern D2 may be formed simultaneously with the cathode CE by a process, and then be separated from the cathode CE by the undercut shape of the bank PW.

The third dummy pattern D3 may include a conductive material. For example, the third dummy pattern D3 and the auxiliary electrode SE may include the same material as each other. The third dummy pattern D3 may be formed simultaneously with the auxiliary electrode SE by a single process, and then be separated from the auxiliary electrode SE due to the undercut shape of the bank PW.

In the case that the display element layer DP-OLED further includes the capping pattern, the dummy patterns DMP may further include a fourth dummy pattern. The fourth dummy pattern may include a conductive material. For example, the fourth dummy pattern and the capping pattern may include the same material as each other. The fourth dummy pattern may be formed simultaneously with the capping pattern by a single process, and then be separated from the capping pattern due to the undercut shape of the bank PW.

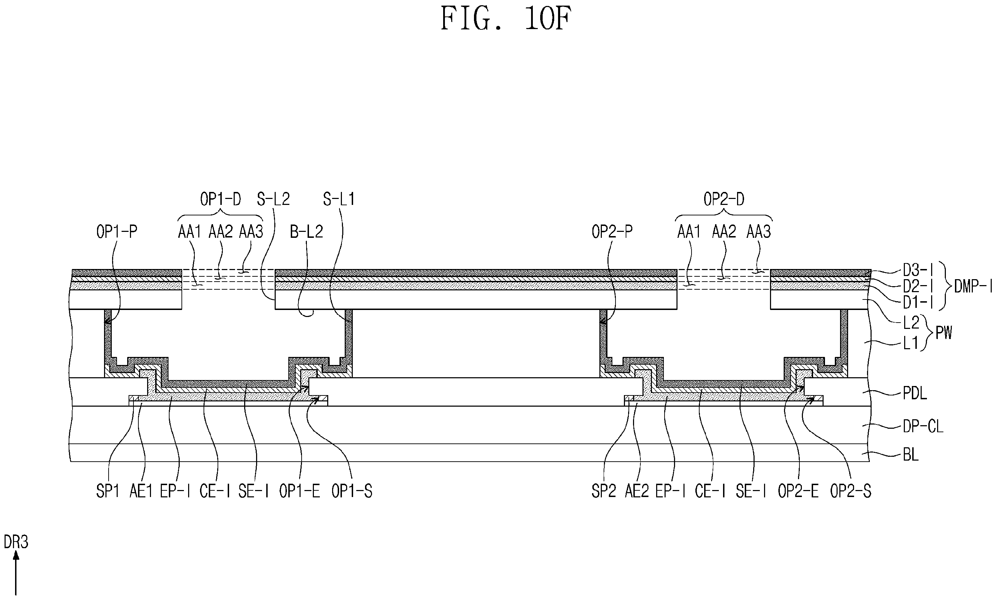

A dummy opening portion OP-D may be defined (or formed) in the dummy patterns DMP. The dummy opening portion OP-D may overlap the light emitting opening portion OP-E. The dummy opening portion OP-D may include first to third areas arranged in sequence in the third direction DR3. A first area AA1 (FIG. 10F) of the dummy opening portion OP-D may be defined by an inner side surface of the first dummy pattern D1, a second area AA2 (see FIG. 10F) may be defined by an inner side surface of the second dummy pattern D2, and a third area AA3 (see FIG. 10 F) may be defined by an inner side surface of the third dummy pattern D3. Each of the first to third dummy patterns D1, D2 and D3 may have a closed line shape surrounding the light emitting area PXA in plan view.

FIG. 6 illustrates an example in which the inner side surfaces of the first to third dummy patterns D1, D2 and D3 are aligned with the second inner side surface S-L2 of the second bank layer L2. However, embodiments are not limited thereto, and the first to third dummy patterns D1, D2 and D3 may cover the second inner side surface S-L2 of the second bank layer L2.

The thin film encapsulation layer TFE may be disposed on the display element layer DP-OLED. The thin film encapsulation layer TFE may include the lower inorganic encapsulation pattern LIL, an organic encapsulation film OL, and an upper inorganic encapsulation film UIL.

The lower inorganic encapsulation pattern LIL may be disposed on the auxiliary electrode SE. The lower inorganic encapsulation pattern LIL may be provided to correspond to the light emitting opening portion OP-E. The lower inorganic encapsulation pattern LIL may be in direct contact with the auxiliary electrode SE. For example, a portion of the lower inorganic encapsulation pattern LIL may cover the auxiliary electrode SE in the bank opening portion OP-P.

The lower inorganic encapsulation pattern LIL may include a silicon nitride (SiNₓ). The lower inorganic encapsulation pattern LIL may have a refractive index of about 1.9 or about 1.89. The lower inorganic encapsulation pattern LIL may have a refractive index that is greater than or equal to the refractive index of the auxiliary electrode SE described above.

The organic encapsulation film OL may cover the lower inorganic encapsulation pattern LIL, and provide a flat top surface. The upper inorganic encapsulation film UIL may be disposed on the organic encapsulation film OL.

The lower inorganic encapsulation pattern LIL and the upper inorganic encapsulation film UIL may protect the display element layer DP-OLED from moisture/oxygen, and the organic encapsulation film OL may protect the display element layer DP-OLED from a foreign matter such as dust particles.

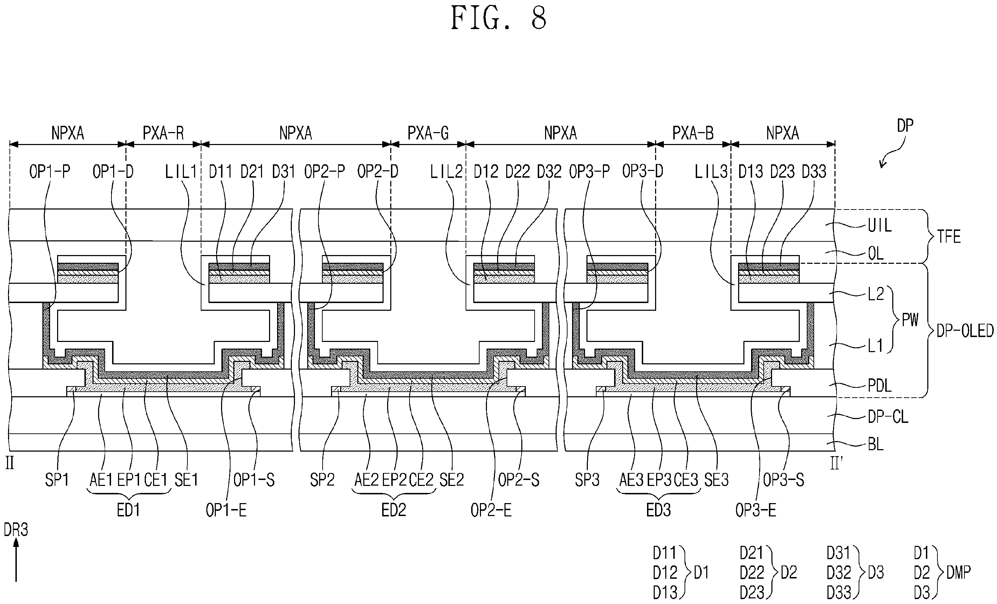

FIG. 8 is a schematic cross-sectional view of a portion of a display panel according to an embodiment. FIG. 8 is a schematic cross-sectional view taken along line II-II' in FIG. 5.

FIG. 8 illustrates an enlarged schematic view of one first light emitting area PXA-R, one second light emitting area PXA-G, and one third light emitting area PXA-B. The same/similar description of one light emitting area PXA in FIG. 6 may apply to each of the first to third light emitting areas PXA-R, PXA-G and PXA-B.

Referring to FIG. 8, a display panel DP according to an embodiment may include a base layer BL, a circuit element layer DP-CL, a display element layer DP-OLED, and a thin-film encapsulation layer TFE. The display element layer DP-OLED may include light emitting elements ED1, ED2 and ED3, sacrificial patterns SP1, SP2 and SP3, a pixel defining film PDL, a bank PW, auxiliary electrodes SE1, SE2 and SE3, and dummy patterns DMP.

The light emitting elements ED1, ED2 and ED3 may include a first light emitting element ED1, a second light emitting element ED2, and a third light emitting element ED3. The first light emitting element ED1 may include a first anode AE1, a first light emitting pattern EP1, and a first cathode CE1. The second light emitting element ED2 may include a second anode AE2, a second light emitting pattern EP2, and a second cathode CE2. The third light emitting element ED3 may include a third anode AE3, a third light emitting pattern EP3, and a third cathode CE3. The first to third anodes AE1, AE2 and AE3 may be provided as a plurality of patterns. In an embodiment, the first light emitting pattern EP1 may provide (or emit) light having a red color, the second light emitting pattern EP2 may provide (or emit) light having a green color, and the third light emitting pattern EP3 may provide (or emit) light having a blue color.

First to third light emitting opening portions OP1-E, OP2-E and OP3-E may be defined (or formed) in the pixel defining film PDL. The first light emitting opening portion OP1-E may expose at least a portion of the first anode AE1. The second light emitting opening portion OP2-E may expose at least a portion of the second anode AE2. The third light emitting opening portion OP3-E may expose at least a portion of the third anode AE3.

The sacrificial patterns SP1, SP2 and SP3 may include a first sacrificial pattern SP1, a second sacrificial pattern SP2, and a third sacrificial pattern SP3. The first to third sacrificial patterns SP1, SP2 and SP3 may be disposed on top surfaces of the first to third anodes AE1, AE2 and AE3, respectively. First to third sacrificial opening portions OP1-S, OP2-S and OP3-S overlapping the first to third light emitting opening portions OP1-E, OP2-E and OP3-E may be defined (or formed) in the first to third sacrificial patterns SP1, SP2 and SP3, respectively.

In an embodiment, first to third bank opening portions OP1-P, OP2-P and OP3-P overlapping the first to third light emitting opening portions OP1-E, OP2-E and OP3-E, respectively, may be defined (or formed) in the bank PW. The first light emitting area PXA-R may be defined as an area, which is exposed by the first bank opening portion OP1-P, of the top surface of the first anode AE1. The second light emitting area PXA-G may be defined as an area, which is exposed by the second bank opening portion OP2-P, of the top surface of the second anode AE2. The third light emitting area PXA-B may be defined as an area, which is exposed by the third bank opening portion OP3-P, of the top surface of the third anode AE3.

Each of the first to third bank opening portions OP1-P, OP2-P and OP3-P may include the first area A1 (see FIG. 6) and the second area A2 (see FIG. 6), which are described above with reference to FIG. 6. A first bank layer L1 may have the first inner side surfaces S-L1 (see FIG. 6) that define the first areas A1 of the first to third bank opening portions OP1-P, OP2-P and OP3-P, respectively, and a second bank layer L2 may have the second inner side surfaces S-L2 (see FIG. 6) that define the second areas A2 of the first to third bank opening portions OP1-P, OP2-P and OP3-P, respectively.

The first light emitting pattern EP1 and the first cathode CE1 may be disposed in the first bank opening portion OP1-P, the second light emitting pattern EP2 and the second cathode CE2 may be disposed in the second bank opening portion OP2-P, and the third light emitting pattern EP3 and the third cathode CE3 may be disposed in the third bank opening portion OP3-P.

In an embodiment, the first to third light emitting patterns EP1, EP2 and EP3 and the first to third cathodes CE1, CE2 and CE3 may be separated (e.g., physically separated) by the second bank layer L2, which provides tip parts TP, and be defined (or formed) in the light emitting opening portions OP1-E, OP2-E and OP3-E and the bank opening portions OP1-P, OP2-P and OP3-P. As illustrated in the drawing, each of the first to third cathodes CE1, CE2 and CE3 may be in contact with the bank PW, and the first to third light emitting patterns EP1, EP2 and EP3 may be spaced apart from the bank PW in plan view. For example, each of the first to third cathodes CE1, CE2 and CE3 may be in contact with the first inner side surfaces S-L1 of the first bank layer L1. However, embodiments are not limited thereto. For example, each of the first to third cathodes CE1, CE2 and CE3 may be spaced apart from the bank PW in plan view, and is not limited to any one embodiment.

According to an embodiment, first light emitting patterns EP1 may be deposited by being patterned into pixel units by the tip part TP defined (or formed) in the bank PW. For example, the first light emitting patterns EP1 may be formed in common using an open mask, but readily separated into the pixel units by the bank PW.

In the case that a fine metal mask (FMM) is used to pattern the first light emitting patterns EP1, a support spacer protruding from a conductive bank needs to be provided to support the fine metal mask. For example, as the fine metal mask is spaced apart from a base surface, which is subjected to patterning, by a height of the bank and the spacer such that implementation of high resolution may be limited. Moreover, as the fine metal mask is in contact with the spacer, a foreign matter may remain on the spacer or the spacer may be damaged due to stabbing of the fine metal mask after a process of patterning the first light emitting patterns EP1. Accordingly, a defective display panel may be provided.

According to an embodiment, as the bank PW is included, separation (e.g., physical separation) between the light emitting elements ED1, ED2 and ED3 may be readily achieved. Accordingly, drive errors or current leak between adjacent light emitting areas PXA-R, PXA-G and PXA-B may be prevented, and the light emitting elements ED1, ED2 and ED3 may be capable of being driven independently of each other.

As the first light emitting patterns EP1 are patterned without a mask in contact with inner components in the display area DA (see FIG. 1B), a defect rate may be reduced to provide the display panel DP with improved process reliability. As the patterning is possible even without a separate support spacer protruding from the bank PW, the respective surface areas of the light emitting areas PXA-R, PXA-G and PXA-B may be miniaturized to provide the display panel DP readily implemented at high resolution.

For example, as manufacture of a mask having a large surface area is omitted from the manufacture of the display panel DP having a large surface area, process costs may be reduced, and the display panel DP may not be affected by a defect likely to occur in the mask having a large surface area. Accordingly, the display panel DP with improved process reliability may be provided or implemented. The same/similar description of the first light emitting patterns EP1 may apply to the second and third light emitting patterns EP2 and EP3.

The auxiliary electrodes SE1, SE2 and SE3 may include a first auxiliary electrode SE1, a second auxiliary electrode SE2, and a third auxiliary electrode SE3. The first auxiliary electrode SE1 may be disposed on the first light emitting element ED1, the second auxiliary electrode SE2 may be disposed on the second light emitting element ED2, and the third auxiliary electrode SE3 may be disposed on the third light emitting element ED3. Each of the first to third auxiliary electrodes SE1, SE2 and SE3 may extend along the first inner side surface S-L1 (see FIG. 6) of the first bank layer L1, and each of the first to third auxiliary electrodes SE1, SE2 and SE3 may cover end portions (e.g., opposite end portions) of each of the first to third light emitting patterns EP1, EP2 and EP3, and end portions (e.g., opposite end portions) of each of the first to third cathodes CE1, CE2 and CE3.

The first to third auxiliary electrodes SE1, SE2 and SE3 may be in contact with the first inner side surfaces S-L1 of the first bank layer L1, and be in contact with the first to third cathodes CE1, CE2 and CE3, respectively. For example, the first auxiliary electrode SE1 may be electrically connected to the first bank layer L1 and the first cathode CE1, the second auxiliary electrode SE2 may be electrically connected to the first bank layer L1 and the second cathode CE2, and the third auxiliary electrode SE3 may be electrically connected to the first bank layer L1 and the third cathode CE3.

As the first to third auxiliary electrodes SE1, SE2 and SE3 are in contact with the first bank layer L1, the first to third auxiliary electrodes SE1, SE2 and SE3 may be electrically connected to each other to receive a common voltage. The first to third cathodes CE1, CE2 and CE3 may be in contact with the first to third auxiliary electrodes SE1, SE2 and SE3 to receive a common cathode voltage.

The dummy patterns DMP may include first dummy patterns D1, second dummy patterns D2, and third dummy patterns D3.

The first dummy patterns D1 may include (1-1)-th to (1-3)-th dummy patterns D11, D12 and D13 surrounding the first to third light emitting areas PXA-R, PXA-G and PXA-B, respectively, in plan view. Each of the (1-1)-th to (1-3)-th dummy patterns D11, D12 and D13 and each of the first to third light emitting patterns EP1, EP2 and EP3 may, respectively, include the same materials as each other, and be formed by the same process as each other.

The second dummy patterns D2 may include (2-1)-th to (2-3)-th dummy patterns D21, D22 and D23 surrounding the first to third light emitting areas PXA-R, PXA-G and PXA-B, respectively, in plan view. The (2-1)-th to (2-3)-th dummy patterns D21, D22 and D23 and the first to third cathodes CE1, CE2 and CE3 may, respectively, include the same materials as each other, and be formed by the same process as each other.

The third dummy patterns D3 may include (3-1)-th to (3-3)-th dummy patterns D31, D32 and D33 surrounding the first to third light emitting areas PXA-R, PXA-G and PXA-B, respectively, in plan view. The (3-1)-th to (3-3)-th dummy patterns D31, D32 and D33 and the first to third auxiliary electrodes SE1, SE2 and SE3 may, respectively, include the same materials as each other, and be formed by the same process as each other, respectively.

First to third dummy opening portions OP1-D, OP2-D and OP3-D corresponding to the first to third light emitting opening portions OP1-E, OP2-E and OP3-E may be defined (or formed) in the dummy patterns DMP, respectively. Each of the first to third dummy opening portions OP1-D, OP2-D and OP3-D may include first to third areas AA1, AA2 and AA3 (see FIG. 10F) that are arranged in sequence in the third direction DR3. The first dummy opening portion OP1-D may be defined by inner side surfaces of the (1-1)-th, (2-1)-th, and (3-1)-th dummy patterns D11, D21 and D31, the second dummy opening portion OP2-D may be defined by inner side surfaces of the (1-2)-th, (2-2)-th, and (3-2)-th dummy patterns D12, D22 and D32, and the third dummy opening portion OP3-D may be defined by inner side surfaces of the (1-3)-th, (2-3)-th, and (3-3)-th dummy patterns D13, D23 and D33.

The thin-film encapsulation layer TFE may include lower inorganic encapsulation patterns LIL1, LIL2 and LIL3, an organic encapsulation film OL, and an upper inorganic encapsulation film UIL. In an embodiment, the lower inorganic encapsulation patterns LIL1, LIL2 and LIL3 may include a first lower inorganic encapsulation pattern LIL1, a second lower inorganic encapsulation pattern LIL2, and a third lower inorganic encapsulation pattern LIL3. The first to third lower inorganic encapsulation patterns LIL1, LIL2 and LIL3 may overlap the first to third light emitting opening portions OP1-E, OP2-E and OP3-E, respectively.

The first lower inorganic encapsulation pattern LIL1 may cover the first auxiliary electrode SE1 and the (1-1)-th, (2-1)-th, and (3-1)-th dummy patterns D11, D21 and D31, and may have a portion disposed inside the first bank opening portion OP1-P. The second lower inorganic encapsulation pattern LIL2 may cover the second auxiliary electrode SE2 and the (1-2)-th, (2-2)-th, and (3-2)-th dummy patterns D12, D22 and D32, and may have a portion disposed inside the second bank opening portion OP2-P. The third lower inorganic encapsulation pattern LIL3 may cover the third auxiliary electrode SE3 and the (1-3)-th, (2-3)-th, and (3-3)-th dummy patterns D13, D23 and D33, and may have a portion disposed inside the third bank opening portion OP3-P. The first to third lower inorganic encapsulation patterns LIL1, LIL2 and LIL3 may be provided (or formed) in the form of patterns spaced apart from each other.

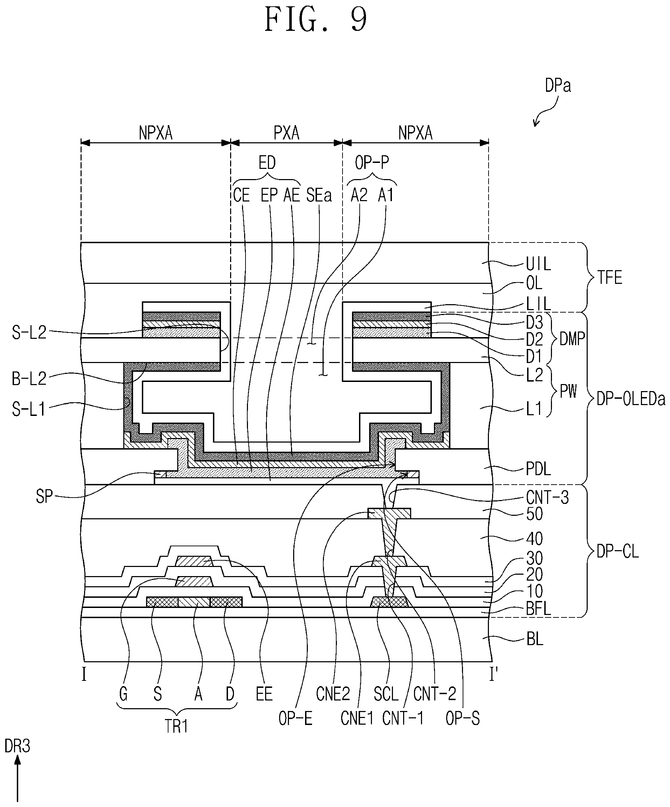

FIG. 9 is an enlarged schematic cross-sectional view of a portion of a display panel according to an embodiment. FIG. 9 is a schematic cross-sectional view, which is taken along line I-I' in FIG. 5, of the display panel according to an embodiment. An embodiment will be described with reference to FIG. 9 by denoting the same/similar components as/to those described with reference to FIG. 6 as the same/similar reference numbers or symbols, and omitting redundant description.

Referring to FIG. 9, a display panel DPa may include a base layer BL, a circuit element layer DP-CL, a display element layer DP-OLEDa, and a thin-film encapsulation layer TFE. The display element layer DP-OLEDa may include a light emitting element ED, a sacrificial pattern SP, a pixel defining film PDL, a bank (or partition wall) PW, an auxiliary electrode SEa, and a dummy pattern DMP. A shape of the auxiliary electrode SEa in FIG. 9 may be different from the shape of the auxiliary electrode SE in FIG. 6.

The auxiliary electrode SEa may be disposed on the light emitting element ED. For example, the auxiliary electrode SEa may be disposed on a cathode CE. A portion of the auxiliary electrode SEa may be disposed in a bank opening portion OP-P. The auxiliary electrode SEa in FIG. 9 may extend along a first inner side surface S-L1 of a first bank layer L1 and a bottom surface B-L2 of a second bank layer L2, and the auxiliary electrode SEa may cover end portions (e.g., opposite end portions) of a light emitting pattern EP and end portions (e.g., opposite end portions) of the cathode CE. FIG. 9 illustrates an example in which the auxiliary electrode SEa extends to be aligned with a second inner side surface S-L2 of the second bank layer L2. However, embodiments are not limited thereto. For example, the auxiliary electrode SEa may extend only to a middle portion of the bottom surface B-L2 of the second bank layer L2.

The auxiliary electrode SEa may have conductivity. For example, the auxiliary electrode SEa may include a titanium nitride (TiN). In another embodiment, the auxiliary electrode SEa may include a transparent conductive oxide (TCO). For example, the auxiliary electrode SEa may include an indium tin oxide (ITO) or an indium zinc oxide (IZO). However, embodiments are not limited thereto, and the auxiliary electrode SEa may be made of various materials such as a conductive polymeric material, as long as the auxiliary electrode SEa is capable of having conductivity.

The auxiliary electrode SEa may be in contact with the first inner side surface S-L1 of the first bank layer L1, and be in contact with the cathode CE. For example, the auxiliary electrode SEa may be electrically connected to the bank PW and the cathode CE. The bank PW may receive the second driving voltage ELVSS (see FIG. 4), and the auxiliary electrode SEa may be electrically connected to the bank PW to receive the second driving voltage ELVSS. Accordingly, the cathode CE electrically connected to the auxiliary electrode SEa may receive the second driving voltage ELVSS.

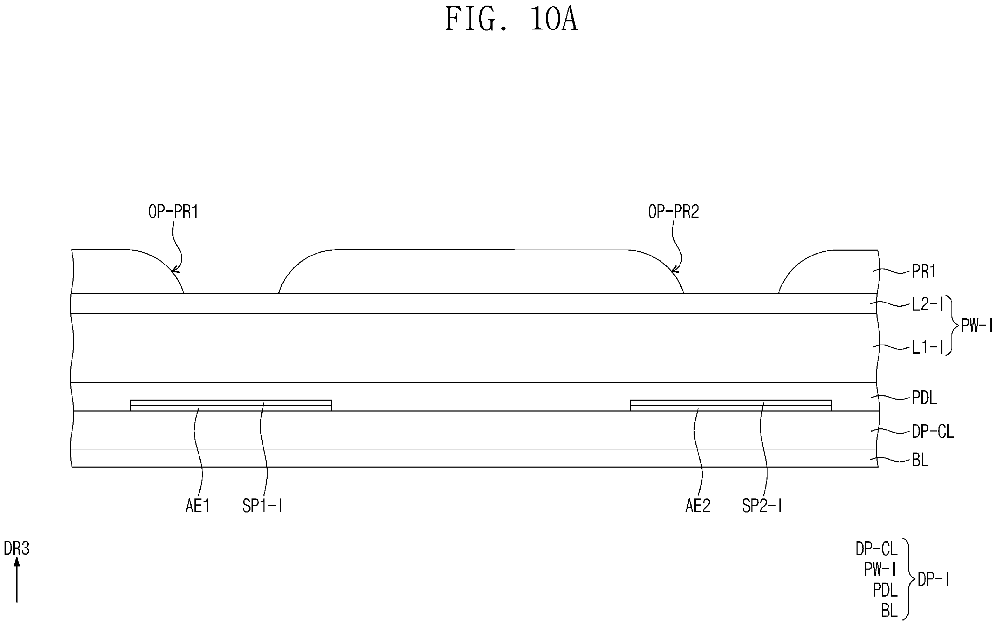

FIGS. 10A to 10J are schematic cross-sectional views illustrating some of operations of a method for manufacturing a display panel according to an embodiment. An embodiment will be described with reference to FIGS. 10A to 10J by denoting the same/similar components as/to those described with reference to FIGS. 1A to 9 as the same/similar reference numbers or symbols, and omitting redundant description.

The method for manufacturing the display panel DP according to an embodiment may include providing a preliminary display panel including a base layer, an anode disposed on the base layer, and a preliminary pixel defining film that is disposed on the base layer and covers the anode, forming a bank which is disposed on the preliminary pixel defining film, and in which a bank opening portion is formed, patterning the preliminary pixel defining film to form a light emitting opening portion, which overlaps the bank opening portion and exposes at least a portion of the anode, so that a pixel defining film may be formed, forming a light emitting layer, a cathode disposed on the light emitting layer, and a preliminary auxiliary electrode in contact with the bank in the bank opening portion, doping the preliminary auxiliary electrode with a group 2 element to form an auxiliary electrode, and forming an encapsulation layer that covers the bank opening portion and has a refractive index greater than or equal to a refractive index of the auxiliary electrode.

Hereinafter, a method for forming two light emitting elements ED1 and ED2, and lower inorganic encapsulation patterns LIL1 and LIL2, an organic encapsulation film OL, and an upper inorganic encapsulation film UIL, which cover the light emitting elements ED1 and ED2, will be described with reference to FIGS. 10A to 10J. A portion of the display panel DP in FIG. 6 as an example of a display panel DP, which is formed by the method described with reference to FIGS. 10A to 10J, is illustrated.

Referring to FIG. 10A, the method for manufacturing the display panel DP according to an embodiment may include providing a preliminary display panel DP-I. The preliminary display panel DP-I may include a base layer BL, a circuit element layer DP-CL, first and second anodes AE1 and AE2, first and second preliminary sacrificial patterns SP1-I and SP2-I, a pixel defining film PDL, a first preliminary bank layer L1-I, and a second preliminary bank layer L2-I.

The circuit element layer DP-CL may be formed by a process (e.g., typical process) for manufacturing a circuit element by forming an insulation layer, a semiconductor layer, and a conductive layer through a method such as coating or deposition, and then selectively patterning the insulation layer, the semiconductor layer, and the conductive layer by a photolithography process and an etching process to form a semiconductor pattern, a conductive pattern, signal lines, and the like.

The first anode AE1 and the first preliminary sacrificial pattern SP1-I may be formed by the same patterning process, and the second anode AE2 and the second preliminary sacrificial pattern SP2-I may be formed by the same patterning process. The pixel defining film PDL may be disposed on the base layer BL. The pixel defining film PDL may cover the first and second anodes AE1 and AE2 and the first and second preliminary sacrificial patterns SP1-I and SP2-I. The pixel defining film PDL may cover all of the first and second anodes AE1 and AE2 and the first and second preliminary sacrificial patterns SP1-I and SP2-I.

The first preliminary bank layer L1-I may be disposed on the pixel defining film PDL. The first bank layer L1-I may be formed by deposition of a conductive material. The second preliminary bank layer L2-I may be disposed on the first preliminary bank layer L1-I. The second bank layer L2-I may be formed by deposition of a conductive material. In an embodiment, the first preliminary bank layer L 1-I may include aluminium (Al) or molybdenum (Mo), and the second preliminary bank layer L2-I may include titanium (Ti). However, the materials of the first preliminary bank layer L1-I and the second preliminary bank layer L2-I are not limited thereto. The first preliminary bank layer L1-I and the second preliminary bank layer L2-I may form a preliminary bank PW-I.

Thereafter, the method for manufacturing the display panel DP according to an embodiment may include forming a first photoresist layer PR1 on the preliminary bank PW-I. The first photoresist layer PR1 may be formed by forming a preliminary photoresist layer on the preliminary bank PW-I and then patterning the preliminary photoresist layer by using a photo mask. A first photo opening portion OP-PR1 and a second photo opening portion OP-PR2 may be formed in the first photoresist layer PR1 by a patterning process. The first photo opening portion OP-PR1 may overlap the first anode AE1, and the second photo opening portion OP-PR2 may overlap the second anode AE2.

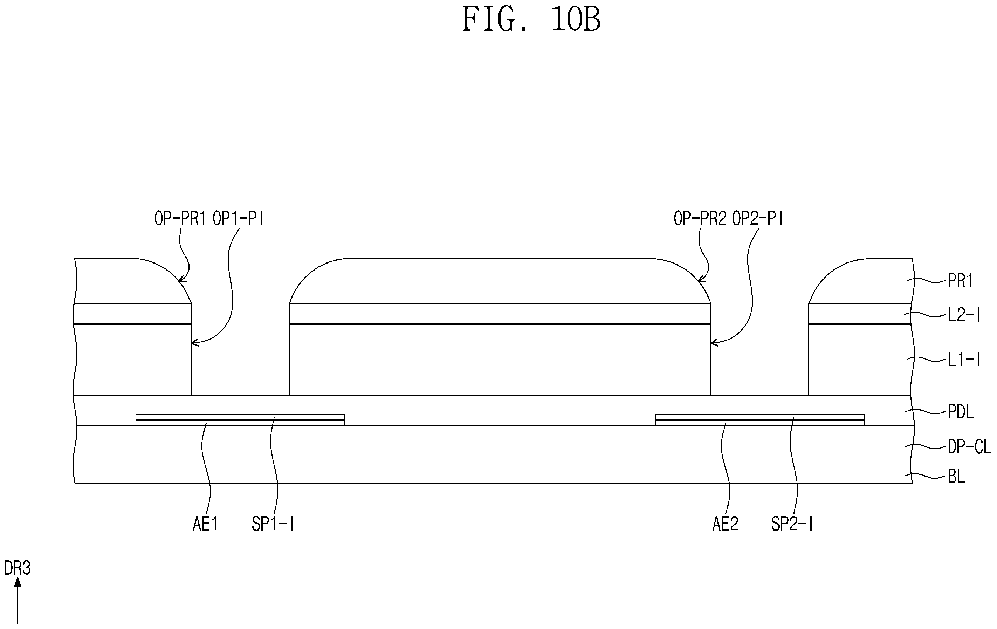

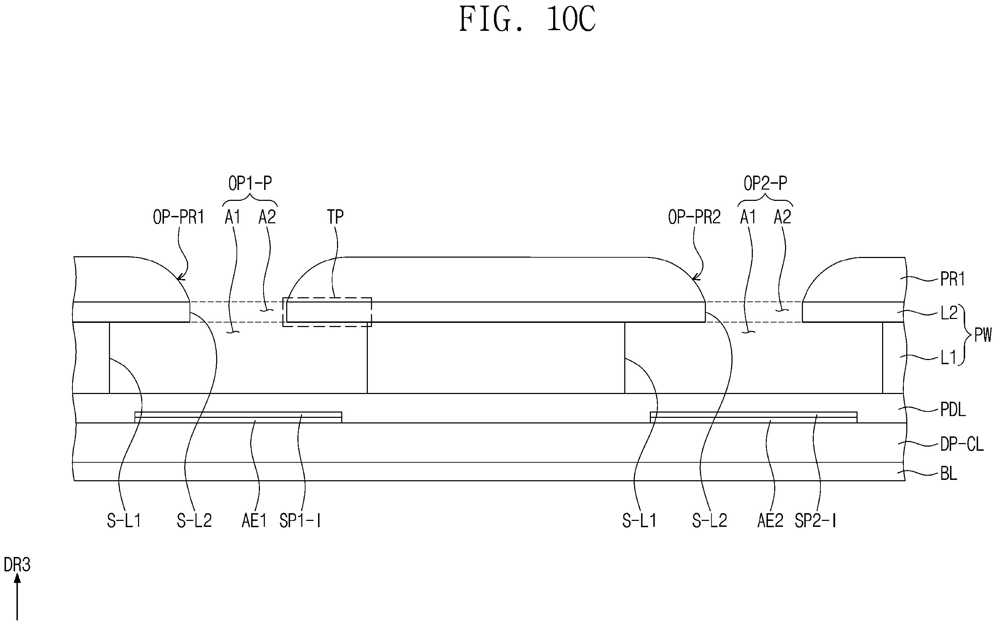

Then, referring to FIGS. 10B and 10C, the method for manufacturing the display panel DP according to an embodiment may include etching the first preliminary bank layer L1-I and the second preliminary bank layer L2-I to form a first bank layer L1 and a second bank layer L2, in which the bank opening portions OP1-P and OP2-P are defined, so that a bank PW may be formed from the preliminary bank PW-I (see FIG. 10A).

As illustrated in FIG. 10B, first etching of the first preliminary bank layer L1-I and the second preliminary bank layer L2-I may include forming the preliminary bank opening portions OP1-PI and OP2-PI in the preliminary bank PW-I (see FIG. 10A) by using the first photoresist layer PR1 as a mask and dry etching the first preliminary bank layer L1-I and the second preliminary bank layer L2-I. The preliminary bank opening portions OP1-PI and OP2-PI may include a first preliminary bank opening portion OP1-PI and a second preliminary bank opening portion OP2-PI. The first preliminary bank opening portion OP1-PI may be formed to overlap the first anode AE1, and the second preliminary bank opening portion OP2-PI may be formed to overlap the second anode AE2.

The first dry etching process in an embodiment may be performed in an etching environment in which etch selectivities of the first preliminary bank layer L1-I and the second preliminary bank layer L2-I are substantially the same as each other. Accordingly, the inner side surface of the first preliminary bank layer L1-I and the inner side surface of the second preliminary bank layer L2-I, which define the preliminary bank opening portions OP1-PI and OP2-PI, may be substantially aligned with each other.

Thereafter, as illustrated in FIG. 10C, second etching of the first preliminary bank layer L1-I (see FIG. 10B) may include forming bank opening portions OP1-P and OP2-P from the preliminary bank opening portions OP1-PI and OP2-PI (see FIG. 10B) by using the first photoresist layer PR1 as a mask and wet etching the first preliminary bank layer L 1-I. The bank opening portions OP1-P and OP2-P may include a first bank opening portion OP1-P and a second bank opening portion OP2-P. The first bank opening portion OP1-P may be formed to overlap the first anode AE1, and the second bank opening portion OP2-P may be formed to overlap the second anode AE2.

Each of the bank opening portions OP1-P and OP2-P may include a first area A1 and a second area A2 that are disposed in sequence in a thickness direction (e.g., third direction DR3). The first bank layer L1 may have a first inner side surface S-L1 that defines the first area A1 of each of the bank opening portions OP1-P and OP2-P, and the second bank layer L2 may have a second inner side surface S-L2 that defines the second area A2.

Referring to FIGS. 6, 7, and 10C, the forming of the first bank layer L1 and the second bank layer L2 may include forming, on the second bank layer L2, a tip part TP protruding from the first bank layer L1 toward the bank opening portions OP1-P and OP2-P. A second wet etching process in an embodiment may be performed in an etching environment in which a difference in etch selectivity between the first preliminary bank layer L1-I (see FIG. 10B) and the second preliminary bank layer L2-I (see FIG. 10B) is great. Accordingly, the inner side surface of the bank PW, which defines each of the bank opening portions OP1-P and OP2-P, may have an undercut shape on a cross-section. For example, as the first bank layer L1 has a higher etch rate for an etchant than an etch rate of the second bank layer L2, the first bank layer L1 may be mainly etched. Accordingly, the first inner side surface S-L1 of the first bank layer L1 may be formed to be recessed inward from the second inner side surface S-L2 of the second bank layer L2. The tip part TP may be formed on the bank PW and may include a portion of the second bank layer L2, which protrudes from the first bank layer L1. Herein, the pixel defining film PDL before the formation of the light emitting opening portion, as shown in FIGS. 10A to 10C, may be referred to as the preliminary pixel defining film.

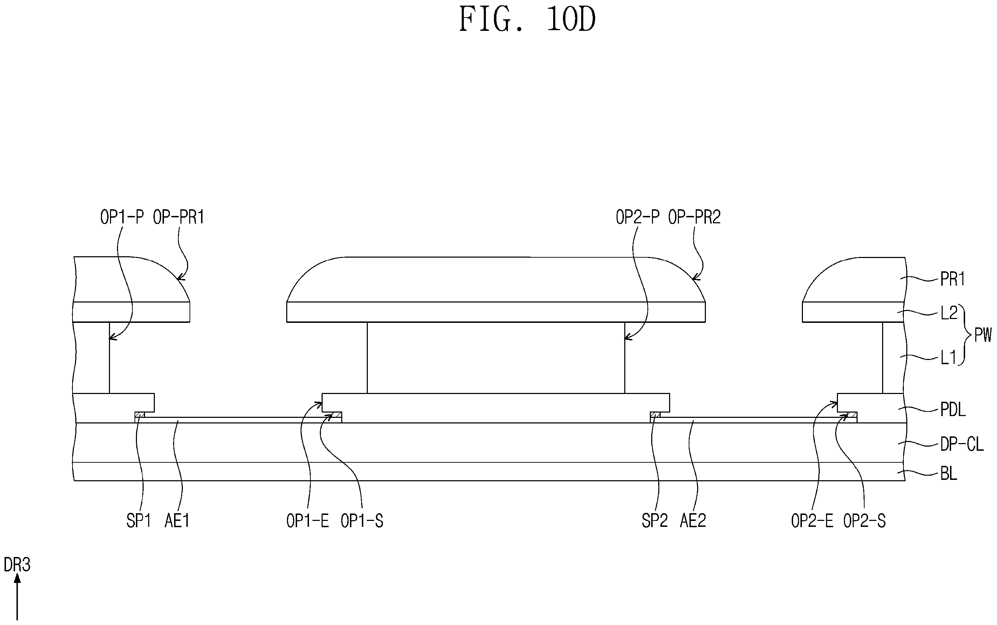

Thereafter, referring to FIG. 10D, the method for manufacturing the display panel DP according to an embodiment may include etching the pixel defining film PDL and etching the preliminary sacrificial patterns SP1-I and SP2-I (see FIG. 10C). The etching of the pixel defining film PDL may be performed using a dry etching method, and may be performed using, as a mask, the first photoresist layer PR1 and the bank PW (e.g., second bank layer L2). Light emitting opening portions OP1-E and OP2-E, which correspond to the bank opening portions OP1-P and OP2-P, respectively, may be formed in the pixel defining film PDL. The light emitting opening portions OP1-E and OP2-E may include a first light emitting opening portion OP1-E and a second light emitting opening portion OP2-E.

The etching of the preliminary sacrificial patterns SP1-I and SP2-I (see FIG. 10C) may be performed using a wet etching method, and may be performed using, as a mask, the first photoresist layer PR1 and the bank PW (e.g., second bank layer L2). Sacrificial opening portions OP1-S and OP2-S, which overlap the light emitting opening portions OP1-E and OP2-E, may be formed in sacrificial patterns SP1 and SP2 formed by etching the preliminary sacrificial patterns SP1-I and SP2-I (see FIG. 10C), respectively.

The sacrificial patterns SP1 and SP2 may include a first sacrificial pattern SP1 and a second sacrificial pattern SP2. A first sacrificial opening portion OP1-S overlapping the first light emitting opening portion OP1-E may be formed in the first sacrificial pattern SP1, and a second sacrificial opening portion OP2-S overlapping the second light emitting opening portion OP2-E may be formed in the second sacrificial pattern SP2. At least a portion of the first anode AE1 may be exposed from the first sacrificial pattern SP1 and the pixel defining film PDL by the first sacrificial opening portion OP1-S and the first light emitting opening portion OP1-E. At least a portion of the second anode AE2 may be exposed from the second sacrificial pattern SP2 and the pixel defining film PDL by the second sacrificial opening portion OP2-S and the second light emitting opening portion OP2-E.

The etching of the sacrificial patterns SP1 and SP2 may be performed in an etching environment in which a difference in etch selectivity between each of the sacrificial patterns SP1 and SP2 and each of the anodes AE1 and AE2 is great, and accordingly, the anodes AE1 and AE2 may be prevented from being etched together. For example, each of the sacrificial patterns SP1 and SP2 having higher etch rates than the anodes AE1 and AE2, respectively, may be disposed between the pixel defining film PDL and each of the anodes AE1 and AE2 so that the anodes AE1 and AE2 may be prevented from being etched together and damaged during the etching.

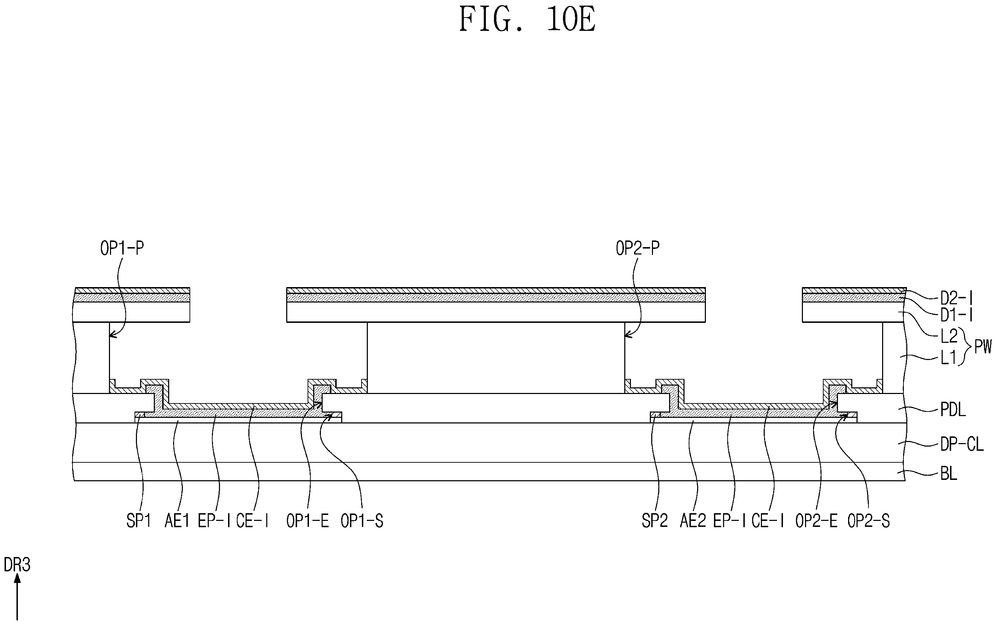

Thereafter, referring to FIGS. 10E to 10H, the method for manufacturing the display panel DP according to an embodiment may include forming a first light emitting pattern EP1 (or light emitting pattern) and a first cathode CE1 (or cathode), and forming a first auxiliary electrode SE1 (or auxiliary electrode), in each of the bank opening portions OP1-P and OP2-P after the first photoresist layer PR1 (see FIG. 10D) is removed.

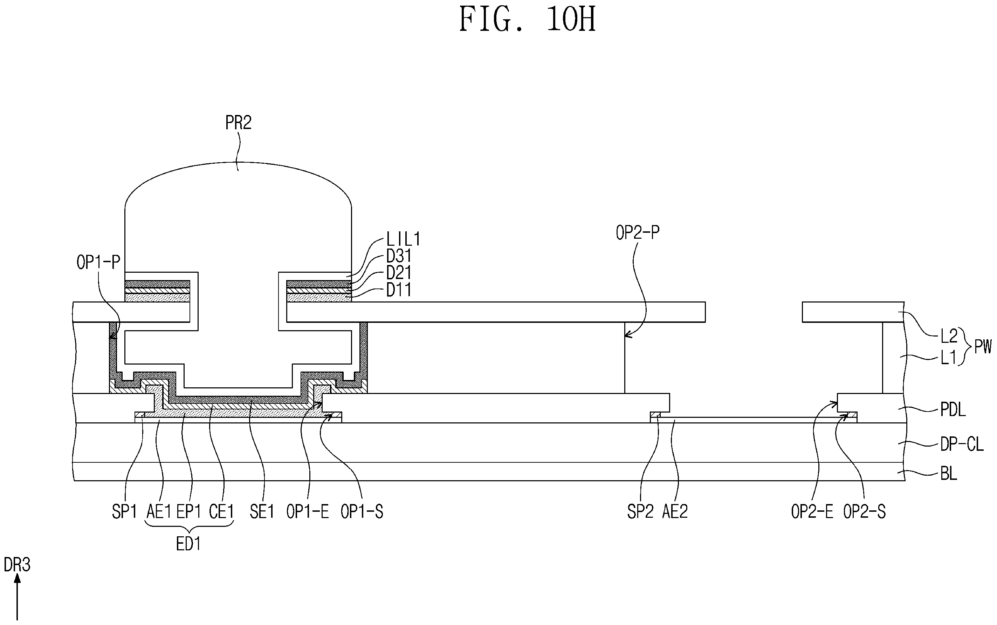

Referring to FIG. 10E, the forming of the first light emitting pattern EP1 (see FIG. 10H) may include depositing a light emitting layer EP-I. A process of depositing the light emitting layer EP-I may include a thermal evaporation process. For example, the forming of the first cathode CE1 (see FIG. 10H) may include depositing a cathode layer CE-I. A process of depositing the cathode layer CE-I may include a thermal evaporation process.

In the forming of the first light emitting pattern EP1, the light emitting layer EP-I may be formed on each of the anodes AE1 and AE2. The light emitting layer EP-I may be separated by the tip part TP formed on the bank PW to be disposed in the light emitting opening portions OP1-E and OP2-E and the bank opening portions OP1-P and OP2-P. The light emitting layer EP-I may be formed to be spaced apart from the second bank layer L2 in each of the bank opening portions OP1-P and OP2-P in plan view. In the forming of the first light emitting pattern EP1, a first dummy layer D1-I spaced apart from the light emitting layer EP-I may be formed on the bank PW together.

In the forming of the first cathode CE1, the cathode layer CE-I may be formed on the light emitting layer EP-I. The cathode layer CE-I may be separated by the tip part TP formed on the bank PW to be disposed in the bank opening portions OP1-P and OP2-P. The cathode layer CE-I may be formed to be spaced apart from the second bank layer L2 in each of the bank opening portions OP1-P and OP2-P in plan view. In the forming of the first cathode CE1, a second dummy layer D2-I spaced apart from the cathode layer CE-I may be formed on the bank PW together.

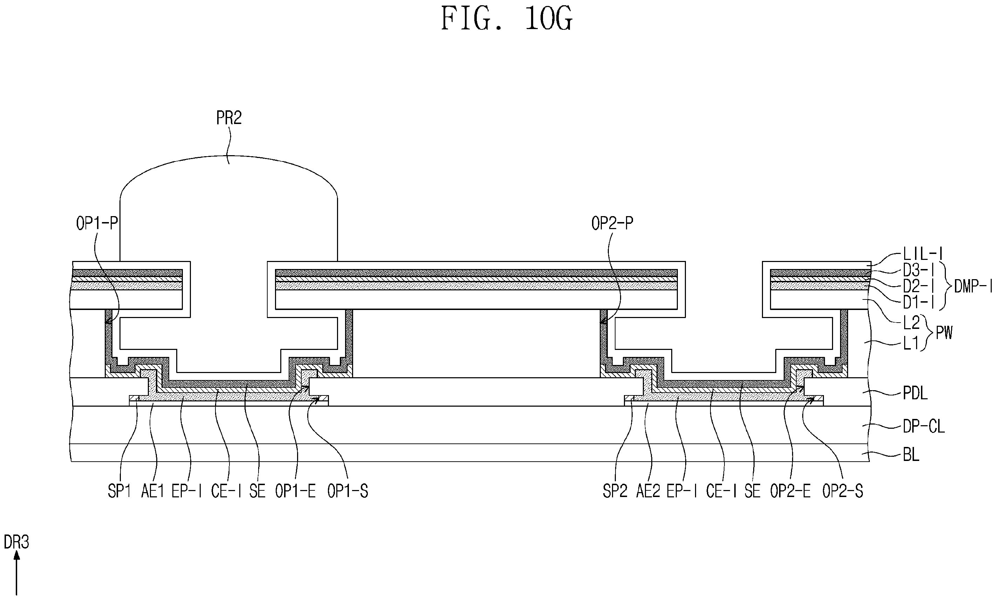

Referring to FIG. 10F, the method may include depositing a preliminary auxiliary electrode SE-I on the cathode layer CE-I, and doping the preliminary auxiliary electrode SE-I with a group 2 element to form an auxiliary electrode SE (see FIG. 10G).

In the forming of the auxiliary electrode SE (see FIG. 10G), the preliminary auxiliary electrode SE-I may be disposed on the cathode layer CE-I. The preliminary auxiliary electrode SE-I may be separated by the tip part TP formed on the bank PW to be disposed in the bank opening portions OP1-P and OP2-P. The preliminary auxiliary electrode SE-I may be formed to cover the light emitting layer EP-I and the cathode layer CE-I. For example, the preliminary auxiliary electrode SE-I may be deposited to cover end portions (e.g., opposite end portions) of the first light emitting pattern EP1 (see FIG. 10H) to be formed thereafter, and end portions (e.g., opposite end portions) of the first cathode CE1 (see FIG. 10H). For example, the preliminary auxiliary electrode SE-I may extend via an end portion of the first cathode CE1 (see FIG. 10H) to be in contact with the first inner side surface S-L1 of the first bank layer L1.

In the forming of the auxiliary electrode SE (see FIG. 10G), a third dummy layer D3-I spaced apart from the preliminary auxiliary electrode SE-I may be formed on the bank PW together.

In an embodiment, the depositing of the preliminary auxiliary electrode SE-I may include a sputtering process. The preliminary auxiliary electrode SE-I may be deposited through sputtering so that the entirety of the first inner side surface S-L1 of the first bank layer L1 may be covered by the preliminary auxiliary electrode SE-I. For example, as the preliminary auxiliary electrode SE-I is deposited through sputtering instead of thermal evaporation, the entirety of the first inner side surface S-L1 of the first bank layer L1 may be covered to improve reliability of an electrical connection.

For example, the preliminary auxiliary electrode SE-I may be deposited by sputtering, and the cathode layer CE-I may be deposited by thermal evaporation so that the preliminary auxiliary electrode SE-I may have a higher step coverage than the cathode layer CE-I. As described above, a size of an area on which the preliminary auxiliary electrode SE-I is in contact with the inner side surface of the first bank layer L1 may be greater than a size of an area on which the cathode layer CE-I is in contact with the inner side surface of the first bank layer L1.

For example, in an embodiment, the preliminary auxiliary electrode SE-I may be provided at a higher incidence angle compared to the light emitting layer EP-I and the cathode layer CE-I so that the preliminary auxiliary electrode SE-I may be formed to be in contact with the first bank layer L1. The preliminary auxiliary electrode SE-I may be formed to extend along the first inner side surface S-L1 of the first bank layer L1.

FIG. 10F illustrates an example in which the preliminary auxiliary electrode SE-I is in contact with the first inner side surface S-L1 of the first bank layer L1. However, embodiments are not limited thereto. For example, the preliminary auxiliary electrode SE-I may extend along the first inner side surface S-L1 of the first bank layer L1 and the bottom surface B-L2 of the second bank layer L2.

The preliminary auxiliary electrode SE-I may be doped with a group 2 element to form the auxiliary electrode SE (see FIG. 10G). The preliminary auxiliary electrode SE-I may include a transparent conductive oxide (TCO). For example, the preliminary auxiliary electrode SE-I may include an indium tin oxide (ITO).

The preliminary auxiliary electrode SE-I may be doped with a group 2 element in an amount of about 1 at% to about 5 at% to form the auxiliary electrode SE (see FIG. 10G). In another example, a group 2 element may be doped in an amount of about 1 at% to about 3 at%.

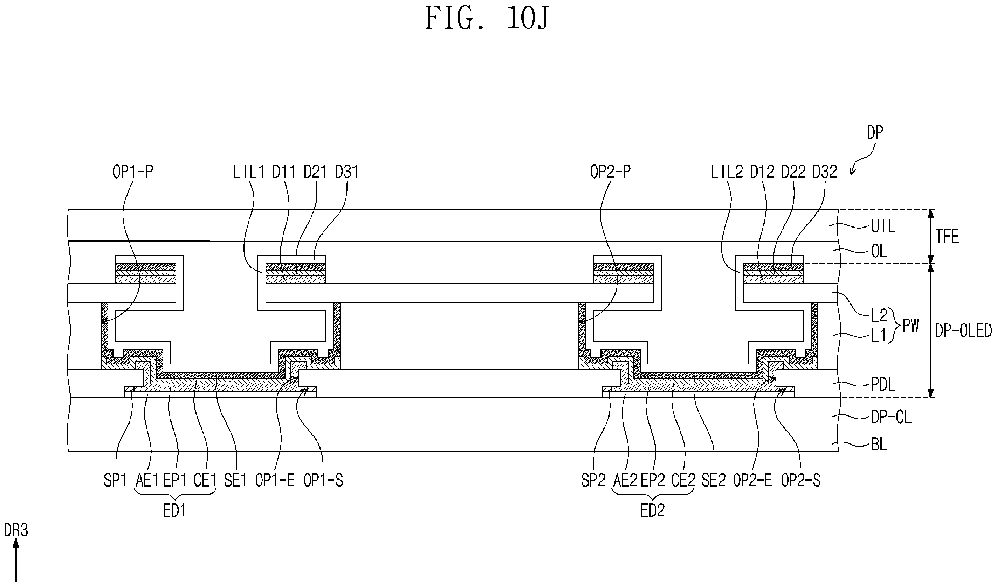

The auxiliary electrode SE (see FIG. 10G) may have a refractive index that is less than or equal to a refractive index of a thin-film encapsulation layer TFE (see FIG. 10J) to be described later. As an example, the auxiliary electrode SE (see FIG. 10G) may have a refractive index that is less than or equal to a refractive index of the lower inorganic encapsulation layer LIL-I (see FIG. 10G). For example, the auxiliary electrode SE (see FIG. 10G) may have a refractive index that is less than or equal to 1.9, a refractive index of the lower inorganic encapsulation layer LIL-I (see FIG. 10G) including a silicon nitride (SiNₓ), and the auxiliary electrode SE (see FIG. 10G) may have a refractive index of about 1.76 to about 1.89.

For example, the auxiliary electrode SE (see FIG. 10G) is not limited to the foregoing indium tin oxide (ITO), and may include an indium zinc oxide (IZO) or other transparent conductive oxides (TCO). The auxiliary electrode SE is not limited to any one embodiment.

The auxiliary electrode SE (see FIG. 10G) may have an amorphous structure, and a thickness of the auxiliary electrode SE (see FIG. 10G) may be about 100 angstrom (Å) to about 1000 angstrom (Å).

The first to third dummy layers D1-I, D2-I and D3-I may form a dummy layer DMP-I, and dummy opening portions OP1-D and OP2-D may be formed in the dummy layer DMP-I. The dummy opening portions OP1-D and OP2-D may include a first dummy opening portion OP1-D and a second dummy opening portion OP2-D. The first dummy opening portion OP1-D may overlap the first bank opening portion OP1-P, and the second dummy opening portion OP2-D may overlap the second bank opening portion OP2-P.

Each of the dummy opening portions OP1-D and OP2-D may include a first area AA1, a second area AA2, and a third area AA3 that are disposed in sequence in the thickness direction (i.e., third direction DR3). The first area AA1 of each of the dummy opening portions OP1-D and OP2-D may be defined by an inner side surface of a first dummy layer D1-I, the second area AA2 may be defined by an inner side surface of a second dummy layer D2-I, and the third area AA3 may be defined by an inner side surface of a third dummy layer D3-I.

Thereafter, referring to FIG. 10G, the method for manufacturing the display panel DP according to an embodiment may include forming the lower inorganic encapsulation layer LIL-I. The lower inorganic encapsulation layer LIL-I may be formed by a depositing process. In an embodiment, the lower inorganic encapsulation layer LIL-I may be formed by a chemical vapor deposition (CVD) process. The lower inorganic encapsulation layer LIL-I may be formed on the bank PW and the auxiliary electrode SE, and a portion of the lower inorganic encapsulation layer LIL-I may be formed inside the bank opening portions OP1-P and OP2-P. The lower inorganic encapsulation layer LIL-I may be formed to be in direct contact with the preliminary auxiliary electrode SE-I. The lower inorganic encapsulation layer LIL-I may have a refractive index that is equal to or greater than the refractive index of the auxiliary electrode SE.

Thereafter, the method for manufacturing the display panel may include forming a second photoresist layer PR2. In the forming of the second photoresist layer PR2, a preliminary photoresist layer may be formed, and then the preliminary photoresist layer may be patterned using a photo mask to form the second photoresist layer PR2. The second photoresist layer PR2 may be formed, by a patterning process, in the form of a pattern corresponding to the first light emitting opening portion OP1-E.

Referring to FIG. 10H, the method for manufacturing the display panel DP according to an embodiment may include patterning the lower inorganic encapsulation layer LIL-I (see FIG. 10G) so that the first lower inorganic encapsulation pattern LIL1 may be formed, patterning the auxiliary electrode SE (see FIG. 10G) other than the first auxiliary electrode SE1, patterning the light emitting layer EP-I (see FIG. 10G) and the cathode layer CE-I (see FIG. 10G) so that the first light emitting pattern EP1 and the first cathode CE1 may be formed, and patterning the dummy layer DMP-I (see FIG. 10G) so that (1-1)-th, (2-1)-th, and (3-1)-th dummy patterns D11, D21 and D31 may be formed.

In the patterning of the lower inorganic encapsulation layer LIL-I, the lower inorganic encapsulation layer LIL-I may be dry-etched to remove a portion, which does not overlap the second photoresist layer PR2, of the lower inorganic encapsulation layer LIL-I. For example, the patterning may be performed so that a portion, which does not overlap the first anode AE1, of the lower inorganic encapsulation layer LIL-I may be removed. The first lower inorganic encapsulation pattern LIL1 overlapping the first light emitting opening portion OP1-E may be formed from the patterned lower inorganic encapsulation layer LIL-I.

In the patterning of the auxiliary electrode SE (see FIG. 10G) other than the first auxiliary electrode SE1, the auxiliary electrode SE (see FIG. 10G) exposed to the outside may be wet-etched to remove a portion, which does not overlap the second photoresist layer PR2, of the auxiliary electrode SE (see FIG. 10G). For example, the patterning may be performed so that a portion, which does not overlap the first anode AE1, of the auxiliary electrode SE (see FIG. 10G) may be removed. Accordingly, the first auxiliary electrode SE1 overlapping the first light emitting opening portion OP1-E may be formed. However, embodiments are not limited thereto. For example, the preliminary auxiliary electrode SE-I may be dry-etched, and it is not limited to any one embodiment.

In the patterning of the light emitting layer EP-I and the cathode layer CE-I, the light emitting layer EP-I and the cathode layer CE-I may be removed by wet etching and a stripper. A portion, which does not overlap the second photoresist layer PR2, of each of the light emitting layer EP-I and the cathode layer CE-I may be removed. For example, the patterning may be performed so that a portion, which does not overlap the first anode AE1, of each of the light emitting layer EP-I and the cathode layer CE-I may be removed. The first light emitting pattern EP1 and the first cathode CE1, each of which overlaps the first light emitting opening portion OP1-E, may be formed from the patterned light emitting layer EP-I and cathode layer CE-I, respectively.

In the patterning of the dummy layer DMP-I, the first to third dummy layers D1-I, D2-I and D3-I (see FIG. 10G) may be dry-etched to remove a portion, which does not overlap the second photoresist layer PR2, of each of the first to third dummy layers D1-I, D2-I and D3-I. For example, the patterning may be performed so that a portion, which does not overlap the first anode AE1, of each of the first to third dummy layers D1-I, D2-I and D3-I may be removed. The (1-1)-th, (2-1)-th, and (3-1)-th dummy patterns D11, D21 and D31, each of which overlaps the first light emitting opening portion OP1-E, may be formed from the patterned first to third dummy layers D1-I, D2-I and D3-I, respectively. Each of the (1-1)-th, (2-1)-th, and (3-1)-th dummy patterns D11, D21 and D31 may have a closed line shape surrounding the light emitting area PXA (see FIG. 6) corresponding thereto in plan view.

The light emitting layer EP-I, the cathode layer CE-I, the auxiliary electrode SE (see FIG. 10G) other than the first auxiliary electrode SE1, and the lower inorganic encapsulation layer LIL-1, which have been formed in the second light emitting opening portion OP2-E and the second bank opening portion OP2-P, may be removed by the patterning process above. For example, the first to third dummy layers D1-I, D2-I and D3-I formed on the bank PW, which do not overlap the first light emitting opening portion OP1-E, may also be removed. The first anode AE1, the first light emitting pattern EP1, and the first cathode CE1, which are formed in the first light emitting opening portion OP1-E and the first bank opening portion OP1-P, may constitute the first light emitting element ED1 after the patterning process.

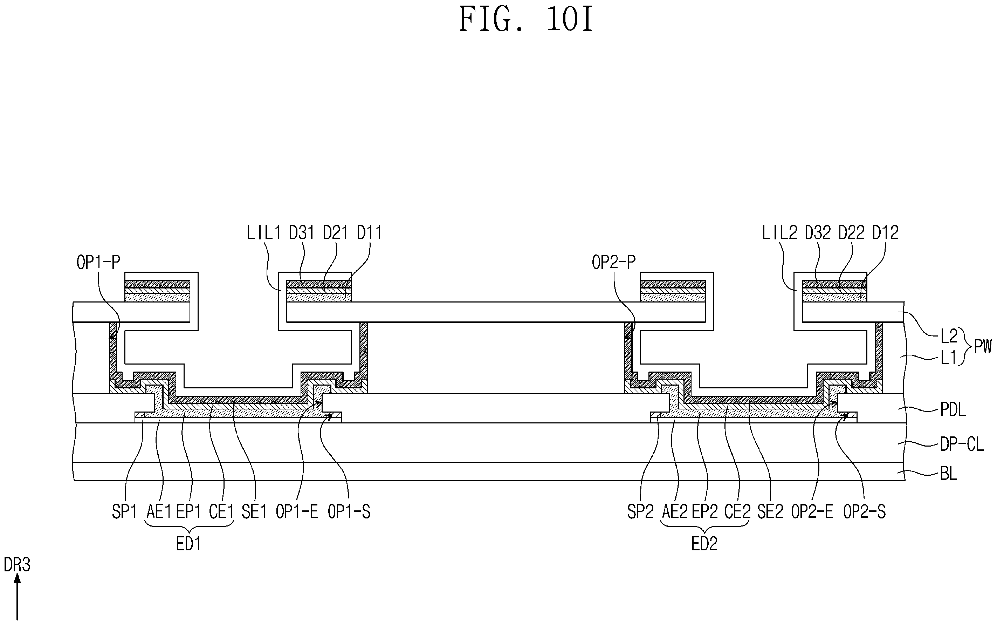

Thereafter, referring to FIG. 10I, in the method for manufacturing the display panel DP according to an embodiment, a second light emitting element ED2 may be formed after the second photoresist layer PR2 (see FIG. 10H) is removed. The process of forming the second light emitting element ED2 may be substantially the same as the process of forming the first light emitting element ED1 described with reference to FIGS. 10E to 10H.

Thereafter, referring to FIG. 10J, the method for manufacturing the display panel DP according to an embodiment may include forming the organic encapsulation film OL and the upper inorganic encapsulation film UIL to complete a display panel DP. An organic material may be applied through an inkjet process to form the organic encapsulation film OL, but embodiments are not limited thereto. The organic encapsulation film OL may provide a planarized top surface. Thereafter, an inorganic material may be deposited to form the upper inorganic encapsulation film UIL. Accordingly, the display panel DP including a base layer BL, a circuit element layer DP-CL, a display element layer DP-OLED, and a thin-film encapsulation layer TFE may be formed.

FIGS. 10A to 10J illustrate, as an example, the method for manufacturing the display panel DP including the first and second light emitting elements ED1 and ED2. Forming the third light emitting element ED3 (see FIG. 8), forming a third auxiliary electrode SE3 (see FIG. 8), and forming a third lower inorganic encapsulation pattern LIL3 (see FIG. 8) may be further included between the forming of the second lower inorganic encapsulation pattern LIL2 overlapping the second light emitting element ED2 and the completing of the display panel DP. Accordingly, the display panel DP may be formed which includes the first to third light emitting elements ED1, ED2 and ED3, the first to third auxiliary electrodes SE1, SE2 and SE3, the first to third dummy patterns D1, D2 and D3, and the first to third lower inorganic encapsulation patterns LIL1, LIL2 and LIL3, which correspond to the light emitting areas PXA-R, PXA-G and PXA-B illustrated in FIG. 8, respectively.

In the display panel and the method for manufacturing the display panel DP according to the embodiment, the light emitting element ED may be formed without using the metal mask.

The display panel DP and the method for manufacturing the display panel DP according to the embodiment may provide the light emitting element ED with the improved process reliability.

The display panel DP and the method for manufacturing the display panel DP according to the embodiment may provide the light emitting element ED with the improved reliability of the electrical connection.

The display panel DP and the method for manufacturing the display panel DP according to the embodiment may provide the light emitting element ED capable of preventing the interference to the light between the auxiliary electrode SE and the thin-film encapsulation layer TFE.

The display panel DP according to the embodiment may include the auxiliary electrode SE connected to each of the cathode CE and the bank PW.

The method for manufacturing the display panel DP according to the embodiment may provide the auxiliary electrode SE extending via the end portion of the cathode to be in contact with the bank.

The display panel DP according to the embodiment may include the auxiliary electrode SE having the refractive index that is less than or equal to the refractive index of the thin-film encapsulation layer TFE.

In the method for manufacturing the display panel DP according to the embodiment, the transparent conductive oxide may be doped with the group 2 element to form the auxiliary electrode SE having the refractive index that is less than or equal to the refractive index of the thin-film encapsulation layer TFE.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display panel comprising:
a base layer;
a pixel defining film disposed on the base layer and comprising a light emitting opening portion;
a bank disposed on the pixel defining film and having conductivity, the bank comprising a bank opening portion overlapping the light emitting opening portion;
a light emitting element disposed in the light emitting opening portion, the light emitting element comprising:
an anode,
an intermediate layer disposed on the anode, and
a cathode disposed on the intermediate layer;
an auxiliary electrode disposed on the cathode, and connected to the cathode and the bank; and
an encapsulation layer covering the light emitting element,
wherein a refractive index of the auxiliary electrode is less than or equal to a refractive index of the encapsulation layer.

2. The display panel of claim 1, wherein the auxiliary electrode comprises a transparent conductive oxide (TCO).

3. The display panel of claim 2, wherein the auxiliary electrode comprises an indium tin oxide (ITO).

4. The display panel of claim 3, wherein the auxiliary electrode further comprises a group 2 element.

5. The display panel of claim 4, wherein a content of the group 2 element included in the auxiliary electrode is in a range of about 1 at% to about 5 at%.

6. The display panel of claim 5, wherein the content of the group 2 element included in the auxiliary electrode is in a range of about 1 at% to about 3 at%.

7. The display panel of any one of claims 1 to 6, wherein the auxiliary electrode has a thickness in a range of about 100 Å to about 1000 Å.

8. The display panel of any one of claims 1 to 7, wherein the refractive index of the auxiliary electrode is in a range of about 1.9 or less in a wavelength range of 380 nm to 760 nm.

9. The display panel of any one of claims 1 to 8, wherein the auxiliary electrode has an amorphous structure.

10. The display panel of any one of claims 1 to 9, wherein
the bank has an undercut shape on a cross-section, and
the bank comprises:
a lower layer comprising a conductive material; and
an upper layer disposed on the lower layer, and
the auxiliary electrode extends along an inner side surface of the lower layer, optionally wherein:
the cathode is in contact with the inner side surface of the lower layer, and
the auxiliary electrode extends via an end portion of the cathode to be in contact with the inner side surface.

11. The display panel of any one of claims 1 to 10, wherein a size of an area, on which the auxiliary electrode is in contact with an inner side surface of the bank, is greater than an area on which the cathode is in contact with the inner side surface of the bank.

12. A method for manufacturing a display panel, the method comprising:
providing a preliminary display panel comprising a base layer, an anode disposed on the base layer, and a preliminary pixel defining film that is disposed on the base layer and covers the anode;
forming a bank disposed on the preliminary pixel defining film and comprising a bank opening portion;
forming a pixel defining film by patterning the preliminary pixel defining film to form a light emitting opening portion, which overlaps the bank opening portion and exposes at least a portion of the anode;
forming a light emitting layer, a cathode disposed on the light emitting layer, and a preliminary auxiliary electrode in contact with the bank in the bank opening portion;
forming an auxiliary electrode by doping the preliminary auxiliary electrode with a group 2 element; and
forming an encapsulation layer covering the bank opening portion and having a refractive index greater than or equal to a refractive index of the auxiliary electrode.

13. The method of claim 12, wherein
the light emitting layer and the cathode are formed by a thermal evaporation method, and
the auxiliary electrode is formed by a different method from the cathode, optionally wherein the auxiliary electrode is formed by a sputtering process.

14. The method of claim 12 or claim 13, wherein the preliminary auxiliary electrode is doped with the group 2 elements so that a content of the group 2 elements included in the auxiliary electrode is in a range of about 1 at% to about 5 at%.

15. The method of any one of claims 12 to 14, wherein the forming of the bank comprises:
forming a first layer on the pixel defining film;
forming a second layer on the first layer;
first etching of patterning the first layer and the second layer so that a first pattern is formed; and
second etching of patterning the first layer and the second layer so that an undercut is formed in the first pattern.
